# FASCICULE DE BREVET EUROPEEN

(11) **EP 3 702 323 B1**
(45) Date de publication et mention de la délivrance du brevet: **06.10.2021**
(21) Numéro de dépôt: 20171331.0
(22) Date de dépôt: 21.07.2014
(51) Int. Cl.: B81B 7/00, B81B 3/00

(54) **DISPOSITIF COMPORTANT UN CANAL FLUIDIQUE MUNI D'AU MOINS UN SYSTEME MICRO OU NANOELECTRONIQUE ET PROCEDE DE REALISATION D'UN TEL DISPOSITIF**
VORRICHTUNG, DIE EINEN MIT MINDESTENS EINEM MIKRO- ODER NANOELEKTRONISCHEN SYSTEM AUSGESTATTETEN FLUIDKANAL UMFASST, UND HERSTELLUNGSVERFAHREN EINER SOLCHEN VORRICHTUNG
DEVICE COMPRISING A FLUID CHANNEL HAVING AT LEAST ONE MICRO OR NANOELECTRONIC SYSTEM AND METHOD FOR PRODUCING SUCH A DEVICE

(30) Priorité: 22.07.2013 FR 1357200
(43) Date de publication de la demande: 02.09.2020
(62) Demande divisionnaire de: 14177871.2
(73) Titulaire: Commissariat à l'énergie atomique et aux énergies alternatives, 75015 Paris (FR)
(72) Inventeur: OLLIER, Eric, 38100 GRENOBLE (FR); MARCOUX, Carine, 38500 VOIRON (FR)
(74) Mandataire: Brevalex

(56) Documents cités:
- US-A1- 2008 283 991
- US-A1- 2012 138 460
- US-B1- 6 548 895

## Description

### DOMAINE TECHNIQUE ET ART ANTÉRIEUR

La présente invention se rapporte à un dispositif comportant un canal fluidique muni d'au moins un système micro ou nanoélectronique et à un procédé de réalisation d'un tel dispositif.

Les notions de systèmes microélectroniques ou nanoélectronique intègrent les systèmes microélectromécaniques ou MEMS (microelectromechanical systems en anglais) et les systèmes nanoélectromécaniques ou NEMS (Nanoelectromechanical systems). Par soucis de simplification ils seront nommés dans le reste de la description MEMS et NEMS. Ces systèmes sont aujourd'hui couramment employés dans de nombreux produits. De nouvelles applications apparaissent notamment du fait du développement des NEMS qui offrent de nouveaux avantages grâce à la réduction des dimensions. En particulier, du fait de la grande sensibilité en masse de ce type de systèmes, ils sont d'un grand intérêt pour les capteurs chimiques ou biologiques.

Un NEMS ou un MEMS comporte une partie fixe et au moins une partie sensible éventuellement suspendue, par rapport à la partie fixe.

Mais pour ces applications en particulier, il est nécessaire de gérer l'exposition de la structure de type MEMS ou NEMS, qui offre des caractéristiques physico-chimiques particulières, à un milieu environnant, en général gazeux ou liquide. Pour cela la structure sensible MEMS ou NEMS est disposée dans un canal fluidique dans lequel s'écoule le milieu et permet la mise en contact du milieu à analyser avec la structure sensible NEMS ou MEMS.

Ces structures sensibles sont reliées à un système électronique d'alimentation et de traitement des signaux par des liaisons électriques, celles-ci reliant la structure au système électronique dont au moins une partie est située à l'extérieur du canal fluidique.

Le canal fluidique est réalisé en rapportant un capot sur un substrat comportant la ou les structures sensibles. Le capot est scellé de manière étanche sur le substrat et comporte au moins deux ouvertures pour assurer la circulation dans le canal du fluide à analyser. Le capot comporte une cavité réalisée dans un substrat, de plusieurs µm à plusieurs centaines de µm de profondeur par exemple.

Le document WO2011/154363 décrit un dispositif d'analyse, par exemple une microcolonne de chromatographie en phase gazeuse comprenant des MEMS et/ou NEMS dans la microcolonne, formant des capteurs. La microcolonne est formée d'un substrat et d'un capot. La connexion des MEMS et/ou NEMS est réalisé par exemple par des vias réalisés dans le substrat et débouchant à l'interface d'assemblage entre le capot et le substrat. Des lignes de connexions relient les vias aux structures sensibles. La présence de ces vias à l'interface d'assemblage rend l'assemblage complexe et, en outre, la connexion électrique des structures sensibles avec l'extérieur est rendue complexe du fait de la réalisation des vias et des lignes de connexion.

Le scellement du capot peut utiliser des techniques de type scellement polymère, scellement moléculaire, scellement anodique, scellement eutectique, frittage verre, etc. Se pose alors le problème de la réalisation des liaisons électriques entre la ou les structures sensibles se trouvant à l'intérieur du canal fluidique et l'extérieur du canal fluidique puisque le scellement, tout en permettant ces liaisons électriques, doit être étanche.

Une technique consiste, après scellement du capot, à ouvrir de larges cavités dans l'épaisseur du capot uniquement au-dessus des zones de plots métallisés pour permettre une reprise de contact directe par wirebonding sur ces plots, chaque plot de contact étant entouré d'un cordon de scellement, par exemple en polymère, pour isoler cette partie de la cavité. Mais cette technique présente l'inconvénient d'introduire des motifs supplémentaires pour ces passages électriques à l'intérieur du canal fluidique ce qui n'est pas souhaitable car ils peuvent être à l'origine de perturbation de la circulation du fluide, de génération de volumes morts, etc. Par ailleurs, cette technique est mal adaptée dans le cas de structures sensibles de type NEMS ou MEMS car ces structures requièrent des plots de contact en matériau semi-conducteur ou en métal de petite taille pour réduire les capacités parasites et être en mesure d'extraire un signal électrique exploitable avec un bon rapport signal/bruit. Enfin cette technique n'est pas adaptée pour des composants formés de NEMS ou MEMS en réseaux, car ceux-ci doivent être interconnectés entre eux avec une densité importante, ce qui implique la mise en œuvre de plots de très petites tailles, et éventuellement mettre en œuvre plusieurs niveaux métalliques.

Une autre technique pour réaliser ces connexions électriques tout en assurant l'étanchéité consiste à réaliser des connexions de type Via, par exemple des TSV (Through Silicon Via en anglais) ou TGV (Through Glass Via en anglais). Le document « 3D MEMS high vaccum wafer level packaging - S. Nicolas et al. Electronic Components and Technology Conference (ECTC), 2012 IEEE 62nd, Date of Conference: May 29 2012-June 1 2012, décrit de telles réalisations. Par exemple, de telles connexions de type TSV seraient par exemple réalisées dans l'épaisseur du capot et déboucheraient dans la cavité, la continuité électrique étant alors assurée par un plot/cordon métallique à l'intérieur de la cavité. Or de tels via seraient réalisés dans des épaisseurs importantes de matériau semi-conducteur, qui peuvent être de l'ordre de plusieurs centaines de µm, ce qui rend la fabrication de contacts de petite taille très difficile. De plus, la présence de TSV traversant le capot et débouchant dans la cavité fluidique peut perturber le fonctionnement du canal fluidique, par exemple en perturbant la propagation du mélange en circulation, en perturbant les propriétés chimiques des interfaces en contact avec le milieu en circulation du fait des matériaux des TSV.... De plus, compte tenu des dimensions du canal, en particulier de la hauteur de la cavité, la liaison électrique entre le TSV dans le capot et la structure sensible serait difficile à réaliser.

Le document US 2008/283991 A1 décrit un dispositif comportant un canal fluidique muni d'un système microélectromécanique. Le dispositif comporte des connexions électriques entre ce système microélectromécanique et l'extérieur du canal fluidique, les connexions électriques étant formées par des vias réalisés à travers le substrat sur lequel repose le système microélectromécanique, et ce à l'aplomb du système microélectromécanique et en contact électrique avec celui-ci. Le document US2012/138460 A1 décrit un biocapteur disposé dans un canal fluidique.

### EXPOSÉ DE L'INVENTION

C'est par conséquent un but de la présente invention d'offrir un dispositif comportant au moins un canal fluidique, une ou plusieurs structures sensibles situées dans le canal fluidique, et des liaisons électriques entre la ou les structures sensibles situées dans le canal fluidique et l'extérieur du canal fluidique ne présentant pas les inconvénients cités ci-dessus.

C'est également un but d'offrir un procédé de réalisation d'un tel dispositif à canal fluidique.

Le but mentionné ci-dessus est atteint par un dispositif comportant un substrat comprenant au moins une structure microélectronique et/ou nanoélectronique comportant au moins une partie sensible et un canal fluidique défini entre ledit substrat et un capot, ledit canal fluidique comportant au moins deux ouvertures pour assurer une circulation dans ledit canal, ladite structure microélectronique et/ou nanoélectronique étant située à l'intérieur du canal fluidique, ledit capot étant assemblé avec le substrat au niveau d'une interface d'assemblage, ledit dispositif comportant au moins une connexion électrique entre ladite structure microélectronique et/ou nanoélectronique et l'extérieur du canal fluidique, ladite connexion électrique étant formée par un via réalisé à travers le substrat à l'aplomb de ladite structure microélectronique et/ou nanoélectronique et en contact électrique avec ladite structure microélectronique et/ou nanoélectronique, le dispositif comportant également une couche de fonctionnalisation recouvrant au moins une partie de la partie sensible de la structure microélectronique et/ou nanoélectronique.

Selon l'invention la structure microélectronique et/ou nanoélectronique comporte une structure fixe dont des plots de contact, au moins une structure sensible et des moyens d'actionnement et/ou de transduction d'au moins une caractéristique de la structure sensible, les plots de contact étant reliés électriquement à la partie sensible et /ou à la partie fixe.

Grâce à l'invention, l'assemblage du capot et du substrat est simplifié. En outre, en réalisant le via à l'aplomb de la structure microélectronique et/ou nanoélectronique, celui-ci est en contact direct avec le plot de contact correspondant. Aucune piste conductrice supplémentaire n'est requise entre le via et son plot de contact. Par ailleurs, le fait de disposer le plot dans le canal fluidique permet de limiter la longueur de piste conductrice nécessaire entre le plot et la partie sensible, voire la partie fixe, et ainsi d'optimiser la qualité en particulier du signal électrique de transduction.

De plus, dans le cas d'un réseau de NEMS/MEMS, il est possible de relier directement chacune des structures NEMS/MEMS présentes dans le canal fluidique de façon individuelle, permettant ainsi par exemple de contrôler et d'optimiser les caractéristiques du réseau.

En outre le ou les vias ne perturbent pas l'écoulement dans le canal puisqu'ils ne débouchent pas dans l'écoulement du fluide, ils sont masqués en dessous la structure microélectronique et/ou nanoélectronique. L'invention permet donc de ne pas recourir à la réalisation de via à travers le capot et/ou à l'ouverture de larges cavités dans l'épaisseur du capot pour permettre une reprise de contact.

En d'autres termes, on réalise les vias à travers le substrat directement en dessous de la structure microélectronique et/ou nanoélectronique.

De manière très avantageuse, une couche intermédiaire peut être prévue entre le capot et le substrat pour faciliter l'assemblage. La couche intermédiaire peut présenter un état de surface permettant le scellement avec les faces de base du capot, par exemple un scellement par film sec, un scellement moléculaire, eutectique ou par thermocompression. La face apte au scellement peut présenter une certaine rugosité ou un certain relief qui permet néanmoins le scellement.

De manière également avantageuse, la couche intermédiaire peut être prévue dans le canal fluidique, la couche intermédiaire peut être telle qu'elle encapsule les matériaux de la structure NEMS ou MEMS, sauf la partie sensible, qui de par leur présence dans le canal fluidique, pourraient interagir avec le milieu en circulation dans le canal, i.e. elle isole les matériaux de la structure NEMS ou MEMS autres que la partie sensible de l'intérieur du canal fluidique. C'est le cas par exemple avec les métaux ou diélectriques qui sont mis en œuvre dans le canal fluidique si la structure mécanique comporte un réseau dense de NEMS. Dans ce cas-là, la couche intermédiaire est de manière avantageuse uniquement ouverte au niveau des structures NEMS ou MEMS destinées à interagir avec le milieu environnant.

La structure sensible est fonctionnalisée.

De manière préférée, l'assemblage est réalisé au moyen d'un film sec, un tel mode d'assemblage est particulièrement adapté dans le cas d'une fonctionnalisation de la structure sensible.

De manière très avantageuse, le ou les via(s) est ou sont réalisé(s) après assemblage du capot sur le substrat, ce qui permet d'amincir le substrat et de réaliser des vias denses, le capot servant de poignée.

Par ailleurs, la structure selon l'invention et son procédé de réalisation permettent une réalisation collective de puces munies d'un canal fluidique, les puces étant séparées par sciage entre les canaux et par des prédécoupes transversales aux canaux.

La présente invention a alors pour objet un dispositif tel que récité dans la revendication 1.

Le via peut être en contact électrique avec la structure microélectronique et/ou nanoélectronique par l'intermédiaire d'un plot de contact situé dans le canal fluidique.

Le dispositif peut très avantageusement comporter une couche intermédiaire située au moins en partie dans le canal fluidique, ladite couche intermédiaire recouvrant, dans le canal fluidique, au moins en partie la structure microélectronique et/ou nanoélectronique à l'exception de sa partie sensible ou une couche intermédiaire située uniquement à l'interface d'assemblage située entre le capot et le substrat.

La couche intermédiaire peut comporter un matériau isolant électrique, tel qu'un oxyde de silicium, ou un nitrure de silicium.

Le dispositif peut comporter plusieurs structures microélectroniques et/ou nanoélectroniques interconnectées dans ledit canal fluidique. Les structures microélectronique et/ou nanoélectronique peuvent interconnectées entre elles par des lignes d'interconnexion situées dans le canal fluidique.

Avantageusement, la couche intermédiaire isole électriquement les lignes d'interconnexion.

Dans un exemple de réalisation, le dispositif comporte un film sec de scellement interposé entre le substrat et le capot. Le film sec de scellement peut comporter plusieurs cordons.

Dans un autre exemple de réalisation, le dispositif comporte au moins une couche de matériau interposée entre le substrat et le capot réalisant un scellement eutectique ou métallique ou par thermo-compression, ou par sérigraphie ou un scellement moléculaire ou un scellement par frittage de verre.

La couche intermédiaire peut avantageusement comporter au moins une première couche planarisante et une deuxième couche déposée sur la première couche, ladite deuxième couche étant en un matériau tel qu'il est peu ou pas sensible à une étape de libération de la structure microélectronique et/ou nanoélectronique. La première couche présente une épaisseur suffisante pour effacer les variations de topologie et elle est avantageusement isolante lorsque la couche intermédiaire est sur les plots de contact de la structure microélectronique et/ou nanoélectronique.

Le canal peut avantageusement former une microcolonne de chromatographie en phase gazeuse.

La présente invention a également pour objet un procédé de réalisation d'au moins un dispositif selon l'invention, tel que récité dans la revendication 8.

L'étape d) a lieu après l'étape c).

La réalisation du via peut comporter au moins
- L'étape de réalisation d'un trou dans une partie au moins du substrat
- L'étape de remplissage de tout ou partie dudit trou avec un matériau conducteur électrique.

Le procédé peut comporter préalablement à la réalisation du au moins un via et après l'étape d), une étape d'amincissement du substrat.

Le procédé peut comporter préalablement à l'étape de remplissage dudit trou avec un matériau conducteur électrique, une étape de dépôt sur la surface interne du trou d'un matériau isolant électrique.

Par exemple, la réalisation du trou est obtenue par une gravure profonde puis par une gravure fine.

Dans le cas où la partie sensible de la structure microélectronique et/ou nanoélectronique est suspendue, celle-ci étant par exemple libérée avant l'étape c).

Le procédé peut également comporter une étape de formation d'une couche intermédiaire sur le substrat après l'étape a) dans une zone telle qu'elle comporte au moins une partie située dans le canal fluidique après l'étape d) ou une étape de formation d'une couche intermédiaire sur le substrat après l'étape a) dans une zone telle qu'elle se situe uniquement à l'interface d'assemblage après l'étape d).

Le procédé peut comporter lors de l'étape a), la réalisation dans la structure microélectronique et/ou nanoélectronique d'au moins un plot de contact électrique destiné à assurer un contact électrique avec le via. Le procédé peut alors comporter en outre pour former ledit plot de contact, un dépôt métallique supplémentaire sur celui-ci.

La procédé peut également comporter une étape de réalisation d'une couche de distribution électrique sur la face du dispositif dans laquelle débouche ledit via.

Dans un exemple de réalisation, l'étape de scellement utilise un film sec, le procédé de réalisation comporte alors les sous-étapes :
- laminage du film sec sur les faces de base des parois du capot,
- structuration du film sec,
- rapprochement du capot et du substrat comportant la ou les structures microélectronique et/ou nanoélectronique,
- application d'une pression de sorte à écraser le film sec.

Dans un autre exemple de réalisation, le scellement est un scellement eutectique ou métallique par thermo-compression, ou par scellement moléculaire ou par sérigraphie.

Plusieurs dispositifs peuvent être réalisés simultanément, le substrat comporte alors plusieurs structures microélectroniques et/ou nanoélectroniques et le substrat capot comporte plusieurs capots, les capots étant scellés simultanément sur le substrat comportant les structures microélectroniques et/ou nanoélectroniques, de sorte qu'un canal fluidique d'un dispositif puisse communiquer ou non avec le canal fluidique d'autres dispositifs.

Le procédé peut comporter les étapes de :
- de réalisation de prédécoupes dans une direction perpendiculaire aux canaux fluidiques dans le substrat capot et dans le substrat,
- de séparation des dispositifs, avantageusement par clivage.
- de prédécoupes ou de découpes dans une direction parallèle aux canaux fluidiques entre les canaux,
   de séparation des dispositifs, avantageusement par clivage des prédécoupes.

### BRÈVE DESCRIPTION DES DESSINS

La présente invention sera mieux comprise à l'aide de la description qui va suivre et des dessins en annexes sur lesquels :
- la figure 1 est une vue de dessus d'un dispositif à canal fluidique intégrant des structures MEMS/NEMS selon un exemple de réalisation ne faisant pas partie de l'invention,
- la figure 2 est une vue en coupe transversale du dispositif de la figure 1 le long du plan A-A',
- la figure 3 est une vue en coupe transversale d'un exemple de dispositif selon l'invention, dans lequel une couche de fonctionnalisation non localisée est mise en oeuvre,
- la figure 4 est une vue en coupe transversale d'un dispositif selon une variante du dispositif de la figure 3 dans lequel une couche de fonctionnalisation localisée est mise en œuvre,
- la figure 5A est une vue de dessus d'un dispositif à canal fluidique intégrant des structures MEMS/NEMS selon un autre exemple de réalisation ne faisant pas partie de l'invention, cet exemple mettant en œuvre une couche intermédiaire entre le capot et le substrat,
- la figure 5B est une vue en coupe transversale du dispositif de la figure 5A le long du plan B-B',
- la figure 6 est une vue en coupe transversale d'un autre exemple de dispositif selon l'invention, dans lequel une couche de fonctionnalisation non localisée est mise en œuvre,
- la figure 7 est une vue en coupe transversale d'un autre exemple de dispositif selon l'invention, dans lequel une couche de fonctionnalisation localisée est mise en œuvre,
- la figure 8A est une vue de dessus d'un dispositif à canal fluidique intégrant des structures MEMS/NEMS selon un autre exemple de réalisation ne faisant pas partie de l'invention, cet exemple mettant en œuvre une couche intermédiaire entre le capot et le substrat et s'étendant à l'intérieur du canal, et délimitant une zone longitudinale sans couche intermédiaire,
- la figure 8B est une vue de dessus d'une variante du dispositif de la figure 8A, l'intérieur du canal sauf la partie sensible de la structure MEMS/NEMS étant recouverte par la couche intermédiaire,
- la figure 8C est une vue en coupe transversale du dispositif de la figure 8A ou celui de la figure 8B, le long du plan CC',
- la figure 9 est une vue en coupe d'un autre exemple de dispositif selon l'invention, dans lequel une couche de fonctionnalisation non localisée est mise en œuvre,
- la figure 10 est une vue en coupe transversale d'un autre exemple de dispositif selon l'invention, dans lequel une couche de fonctionnalisation localisée est mise en oeuvre,
- la figure 11A est une vue de dessus d'un dispositif à canal fluidique intégrant des structures MEMS/NEMS selon un autre exemple de réalisation ne faisant pas partie de l'invention, cet exemple mettant en œuvre une couche intermédiaire uniquement à l'intérieur du canal, et délimitant une zone longitudinale sans couche intermédiaire,
- la figure 11B est une vue en coupe transversale du dispositif de la figure 11A le long du plan DD',
- la figure 12A est une vue de dessus d'un autre exemple de dispositif à canal fluidique ne faisant pas partie de l'invention, exemple dans lequel plusieurs structures MEMS/NEMS sont réalisées,
- la figure 12B est une vue en coupe transversale du dispositif de la figure 12A le long du plan EE',
- la figure 13A est une vue de dessus d'une variante du dispositif à canal fluidique de la figure 12A, dans lequel une couche intermédiaire est formée entre le substrat et le capot et à l'intérieur du canal,
- la figure 13B est une vue en coupe transversale du dispositif de la figure13A le long du plan FF',
- la figure 14 est une vue en coupe d'une variante du dispositif de la figure 12A et 12B comportant des interconnexions entre les MEMS/NEMS,
- la figure 15 est une vue en coupe d'une variante du dispositif de la figure 14A et 14B comportant des interconnexions entre les MEMS/NEMS,
- la figure 16 est une vue en coupe d'un autre exemple de réalisation d'un dispositif ne faisant pas partie de l'invention, dans lequel l'assemblage entre le capot et le substrat est réalisé au moyen d'un film sec,
- la figure 17 est une vue en coupe d'une variante du dispositif de la figure 16 comportant une couche intermédiaire est formée entre le substrat et le capot et à l'intérieur du canal,
- la figure 18 est une vue en coupe d'une variante du dispositif de la figure 16 comportant plusieurs MEMS/NEMS et une couche intermédiaire est formée entre le substrat et le capot et à l'intérieur du canal,
- les figures 19A à 19H sont des représentations schématiques d'étapes d'un exemple de procédé de réalisation du substrat muni d'au moins une structure MEMS ou NEMS pour la réalisation d'un dispositif à canal fluidique selon l'invention,
- les figures 20A à 20D sont des vues schématiques d'étapes d'un exemple de procédé de réalisation d'un capot et de son assemblage avec le substrat comportant la ou les structures MEMS/NEMS pour la réalisation d'un dispositif à canal fluidique selon l'invention,
- les figures 21A à 21F sont des vues schématiques d'étapes d'un exemple de procédé de réalisation de vias dans l'ensemble de la figure 20D,
- les figures 22A à 22C sont des représentations schématiques d'étapes d'un exemple de procédé de réalisation d'un dispositif à canal fluidique ne faisant pas partie de l'invention, ce dispositif ne comportant pas de couche intermédiaire,
- les figures 23A à 23F sont des représentations schématiques d'étapes d'un exemple de procédé de réalisation d'un dispositif à canal fluidique ne faisant pas partie de l'invention, ce dispositif comportant une couche intermédiaire.

### EXPOSÉ DÉTAILLÉ DE MODES DE RÉALISATION PARTICULIERS

Dans la présente demande, on entend par partie NEMS/MEMS une structure mécanique comportant une structure fixe et au moins une structure sensible et des moyens d'actionnement et/ou de transduction d'au moins une caractéristique de la structure sensible.

Des connexions électriques sont prévues pour relier la structure sensible au milieu extérieur. Cette partie MEMS/NEMS peut comporter un réseau de structures NEMS et/ou MEMS, avec éventuellement plusieurs niveaux de métallisation pour réaliser les interconnexions requises. A des fins de simplicité, un MEMS ou un NEMS sera désigné par NEMS.

La "partie sensible" peut être une partie suspendue ou non. Dans la suite de la description, ces deux expressions seront utilisées indifféremment sachant que dans certaines applications de type électromécanique cette partie sensible est mobile.

On entend par "structure NEMS" dans la présente demande, une structure comportant un ou plusieurs NEMS.

Les mêmes références seront utilisées pour désigner les éléments ayant les mêmes fonctions et sensiblement la même forme.

Dans les exemples représentés, le canal fluidique est rectiligne d'axe X, mais un canal ayant une forme courbe, voire en spirale ou tout autre forme ne sort pas du cadre de la présente invention.

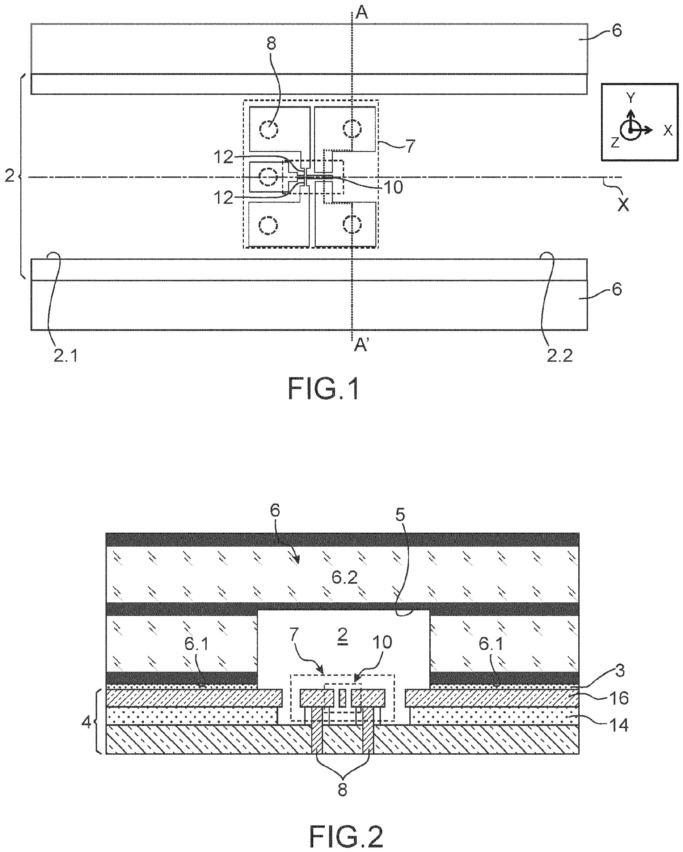

Sur la figure 1, on peut voir en vue de dessus représenté de manière schématique un dispositif à canal fluidique selon un premier exemple de réalisation, le haut du capot étant omis. Sur la figure 2, on peut voir une vue en coupe transversale le long du plan A-A' de la figure 1. Sur cette vue le sommet du capot 6 est représenté.

Le dispositif comporte un canal fluidique 2 qui est rectiligne d'axe X dans l'exemple représenté. Le canal fluidique 2 est délimité par un substrat 4 et un capot 6 reporté sur le substrat 4 et assemblés au niveau d'une interface d'assemblage 3. Par exemple, l'écoulement dans le canal fluidique se fait d'une extrémité longitudinale 2.1 à l'autre 2.2 du canal fluidique 2.

Dans l'exemple représenté, le capot 6 est formé à partir d'un substrat dans lequel une cavité 5 a été ménagée. La cavité 5 délimite avec le substrat portant la structure NEMS/MEMS et l'interface d'assemblage 3 le canal fluidique 2 qui assure la circulation et la distribution d'un mélange gazeux ou liquide. Le canal est délimité par deux parois latérales 6.1, un fond supérieur 6.2 reliant les deux parois latérales 6.1 et un fond inférieur formé par le substrat 4. Les parois latérales 6.1 présentent des faces de base qui permettent le scellement du capot sur le substrat.

Il sera compris que l'extrémité d'entrée et/ou l'extrémité de sortie du canal fluidique pourraient être par exemple réalisées dans le fond supérieur 6.2 du canal ou encore dans le substrat 4.

Alternativement, le capot 6 pourrait présenter une forme plus complexe, par exemple celui-ci pourrait comporter un long canal de forme optimisée, par exemple en spirale, permettant de réaliser une colonne de chromatographie assurant la fonction de séparation des composés d'un mélange, la colonne intégrant une ou plusieurs structures NEMS/MEMS.

Dans l'exemple représenté, le capot 6 est assemblé sur le substrat 4 par scellement.

Le substrat comporte une structure NEMS/MEMS 7 situé à l'intérieur du canal fluidique 2. Dans l'exemple représenté, la structure suspendue du NEMS est formée par une poutre 10 encastrée à l'une de ses extrémités longitudinales, par exemple deux jauges 12, par exemple deux jauges piézorésistives, servent à détecter le déplacement de la poutre 10. On peut voir les extrémités des lignes de connexion 8 connectées à la structure NEMS/MEMS.

Le dispositif comporte également des connexions électriques 8 s'étendant entre le NEMS situé dans le canal fluidique 2 et l'extérieur du canal fluidique. Les connexions électriques 8 sont formées par des vias traversant le substrat 4, également appelés TSV (Through Silicon Via). A des fins de simplicité, les vias traversant le substrat 4 seront désignés par la suite par « via ». Les vias traversent le substrat 4 à l'aplomb de la structure NEMS située dans le canal fluidique et en dehors de la zone d'assemblage, plus particulièrement à l'aplomb de la partie fixe du NEMS. Dans la représentation de la figure 2, les vias sont réalisés sous le NEMS.

De préférence, les vias sont réalisés selon une approche via last, i.e. après la réalisation de la ou des structures NEMS. Les vias présentent alors un diamètre de quelques µm, ils sont bien adaptés aux structures mécaniques et ils offrent des densités relativement élevées puisque le pas entre ces vias peut être de l'ordre de la dizaine de µm. Les vias peuvent être réalisé dans des matériaux différents comme par exemple Cu, W, etc

En variante, des vias de natures et de géométries différentes peuvent être envisagés. Par exemple, les vias peuvent être des trous larges gravés et recouverts d'un matériau conducteur assurant la continuité électrique entre les deux faces du substrat. Alternativement, et de manière préférentielle, les vias peuvent être formés par des trous relativement étroits et complètement remplis avec un matériau plus ou moins conducteur, par exemple par du polysilicium. Un trou étroit a par exemple un diamètre d'environ quelques µm et un trou large a par exemple un diamètre d'environ quelques dizaines de µm à quelques centaines de µm. En variante, encore, on peut envisager par exemple de conserver le matériau semi-conducteur dans lequel est formé le via et remplir la zone périphérique annulaire qui entoure le matériau semi-conducteur par un matériau isolant électrique pour isoler la partie centrale par rapport au reste du substrat.

Par exemple, le ou les via peuvent venir prendre contact avec la face inférieure de la couche 16 dans laquelle le ou les NEMS sont formés. En variante, le ou les vias peuvent venir prendre contact avec la face supérieure de la couche 16, de façon préférentielle par l'intermédiaire d'un plot métallique formé à la surface de la couche 16.

En variante encore, le ou les vias peuvent prendre contact sur une couche d'interconnexion métallique réalisée dans un plan parallèle au plan du ou des NEMS, du côté du canal fluidique, par exemple sur un des niveaux d'interconnexion des réseaux de NEMS qui seront décrits par la suite ou du côté du substrat dans lequel sont réalisés ces motifs de connexion. On pourrait aussi envisager que les vias viennent prendre contact sur une couche d'interconnexion métallique réalisée dans un plan parallèle au plan du ou des NEMS, mais du côté opposé au canal fluidique pour se connecter à des éléments extérieurs situés, par exemple à l'arrière du MEMS

Le substrat 4 comporte un empilement d'une couche sacrificielle 14 utilisée pour la réalisation du NEMS, d'une couche 16 par exemple en semi-conducteur dans laquelle sont réalisées la partie fixe et la partie suspendue du NEMS.

Les vias ne débouchent pas dans l'interface d'assemblage 3, l'interface d'assemblage peut alors être exempte de couche métallique. Il est alors possible de réaliser des assemblages avec des techniques de scellement très performantes en termes de robustesse, de fiabilité et d'herméticité.

D'une part, l'absence de via débouchant dans l'interface de scellement ou de lignes de connexion entre le capot et le substrat permet de disposer d'une surface plane. Ainsi des techniques comme le scellement moléculaire, le scellement eutectique (AuSn, AuSi...), le scellement par thermo-compression métal (Au-Au, Al-Ge) peuvent être envisagées. Les scellements par thermo-compression métal sont particulièrement avantageux parce qu'ils permettent de réduire la température de scellement en dessous de 400°C voire 200°C, ce qui est particulièrement intéressant lorsqu'une couche de fonctionnalisation est mise en œuvre. De même un scellement moléculaire qui peut être effectué à basse température est intéressant pour les mêmes raisons de préservation d'une éventuelle couche de fonctionnalisation.

Dans le cas où le dépôt d'une couche est requis pour le scellement, celle-ci pouvant être éventuellement structurée sur une seule des deux parties, ce qui est le cas pour un scellement eutectique, ce dépôt et cette éventuelle structuration sont effectués de préférence sur le capot. Par exemple pour un eutectique Au-Si, une couche d'Au est déposée de préférence sur le capot.

Dans le cas où le dépôt d'une couche sur chacune des deux parties est requis, par exemple pour un scellement par thermo-compression, le dépôt sur la structure NEMS/MEMS est effectué avant la libération de la structure. Le matériau de cette couche est alors choisi compatible avec le procédé de libération de la structure NEMS/MEMS de sorte qu'elle ne se grave pas lors de cette étape technologique qui intervient juste avant le scellement. On utilisera alors par exemple une couche d'Au sur le capot et sur la couche intermédiaire pour un scellement Au-Au, dans le cas d'une libération des NEMS avec l'acide fluorhydrique en phase vapeur.

Dans le cas d'un scellement moléculaire ou d'un scellement anodique, par exemple dans le cas où le capot est en verre, l'interface de scellement est formée par la face du capot et la face du substrat à sceller. Aucun ajout de matériau n'est requis. Les faces destinées à venir en contact sont préparées de manière connue par l'homme du métier, par exemple par polissage mécano-chimique (ou CMP (chemical-mechanical polishing) en anglais), de la couche 16 et la face inférieure du capot 6.

Un scellement moléculaire en présence d'une couche de fonctionnalisation au niveau de l'interface, la couche de fonctionnalisation étant déposée après libération, est également envisageable.

Avantageusement, les vias sont réalisés après le scellement du capot sur le substrat. Dans ce cas des scellements à température élevée sont envisageables, d'autant plus s'il n'y a pas de structures actives de type CMOS sur le substrat.

En outre, la mise en œuvre de vias dans le canal fluidique permet de réaliser des dispositifs avec un plus grand nombre et/ou une plus grande densité de sorties électriques des structures NEMS contenus dans le canal fluidique vers l'extérieur de ce canal. Il en résulte donc une possibilité d'avoir une plus grande densité de structures NEMS (en réseaux ou non) à l'intérieur du canal fluidique, ce qui est particulièrement intéressant dans le cas d'une microcolonne de chromatographie en phase gazeuse dans laquelle des structures NEMS/MEMS sont réparties tout au long de la microcolonne.

A titre de comparaison, par rapport à des lignes de connexion latérales mettant en œuvre des plots de contact électrique de l'ordre de 100µm x 100µm, cette densité peut être augmentée en réalisant des vias de petits diamètres, par exemple quelques µm ou quelques 10µm de diamètre.

En outre, comme cela a déjà été mentionné ci-dessus, les vias étant réalisés dans le substrat, ils sont réalisés indépendamment de l'épaisseur de la couche « capot ». Il est alors possible de réaliser des vias denses et une cavité profonde. Cet avantage est remarquable en particulier dans le cas d'une microcolonne instrumentée qui requiert des vias denses, imposant un amincissement de l'épaisseur du substrat NEMS a quelques 10µm et une dimension des cavités de la microcolonne d'au moins 100µm. En effet, les dimensions typiques de la section du canal sont de 80×80µm voire plus pour les besoins de l'application de séparation des analytes constituant le mélange gazeux circulant dans le canal. De manière avantageuse, les vias sont réalisés après assemblage avec le capot, ce qui permet alors un amincissement du substrat suffisant, par exemple quelques dizaines de µm, pour réaliser des vias suffisamment denses, le capot assurant la rigidité mécanique

L'invention rend possible la fabrication de dispositif avec des réseaux complexes de NEMS à l'intérieur du canal fluidique et un très bon contrôle de ces réseaux, par un adressage individuel de chaque structure NEMS par l'intermédiaire des TSV.

Par ailleurs, les matériaux à l'interface de scellement tels que le silicium, les métaux, les oxydes...sont en général plus neutres par rapport aux espèces (gaz par exemple), circulant dans le canal fluidique, par rapport à une couche de colle, qui risque de dégazer et peut présenter une affinité chimique perturbante par rapport aux espèces en circulation. Cet avantage est particulièrement intéressant dans l'exemple d'un canal fluidique destiné à la réalisation d'une colonne de chromatographie en phase gazeuse.

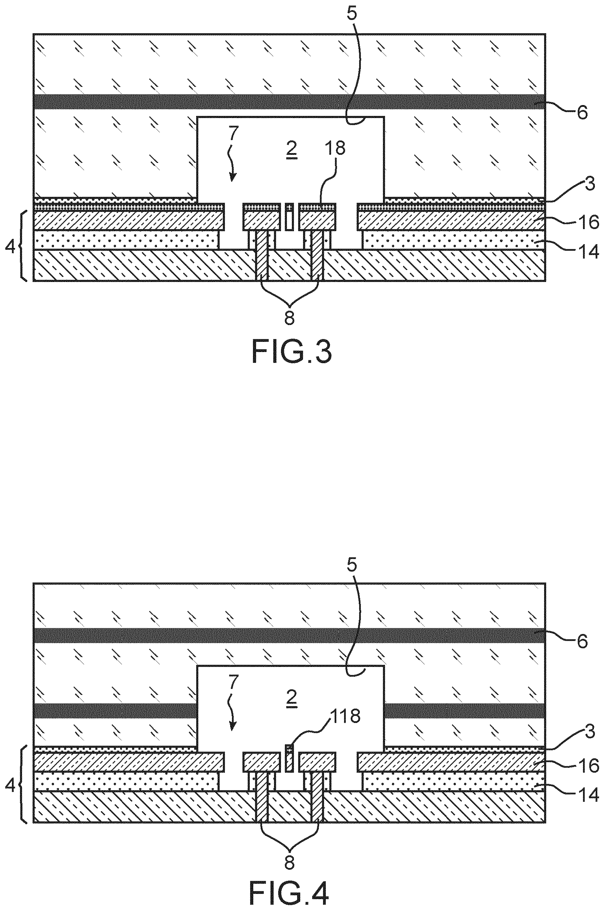

Sur la figure 3, le dispositif comporte une couche de fonctionnalisation 18 recouvrant la couche 16 et toute la structure NEMS/MEMS. Cette couche de fonctionnalisation 18 est dite non localisée.

On entend par "couche de fonctionnalisation" une couche présente à la surface de la structure mécanique pour lui offrir des propriétés particulières. Par exemple dans le cas d'un capteur de gaz, la couche de fonctionnalisation permet d'accroître l'adsorption d'espèces gazeuses de manière éventuellement sélective ou, dans le cas d'un capteur biologique, la couche de fonctionnalisation permet d'assurer le greffage d'espèces biologiques. La couche de fonctionnalisation 18 est par exemple formée d'un ou des plusieurs matériaux organiques ou inorganiques, de polymères, d'oxydes, de composés carbonés, de semi-conducteurs ou autres matériaux poreux...

L'invention permet très avantageusement de réaliser l'étape de dépôt de la couche de fonctionnalisation sur une structure mécanique déjà libérée, ce qui permet d'encapsuler presque totalement la structure mécanique avec la couche de fonctionnalisation lorsque le dépôt de celle-ci est suffisamment conforme. La couche de fonctionnalisation présente alors une surface d'interaction avec le milieu environnant accrue ce qui augmente encore l'intérêt d'une couche de fonctionnalisation. L"invention permet la mise en œuvre de couches de fonctionnalisation sur des NEMS libérés par des techniques sans contact de liquide et collectives, par exemple par dépôt CVD, LPCVD, PECVD, ALD, épitaxie, porosification, etc. et de poursuivre ensuite par la fermeture du composant en rapportant un capot comportant une cavité de manière à former le canal fluidique. Ainsi les risques de collage par dépôt de la couche de fonctionnalisation par dépôt en phase liquide sont évités.

Sur la figure 4, la couche de fonctionnalisation 118 n'est présente que sur la partie sensible du NEMS, la couche de fonctionnalisation est dite localisée.

L'invention permet de réaliser l'étape de dépôt de la couche de fonctionnalisation sur une structure mécanique déjà libérée, ce qui permet d'encapsuler presque totalement la structure mécanique avec la couche de fonctionnalisation lorsque le dépôt de celle-ci est suffisamment conforme. La couche de fonctionnalisation recouvre la face supérieure, la face inférieure et les faces latérales de l'élément suspendu. La couche de fonctionnalisation présente alors une surface d'interaction avec le milieu environnant accrue ce qui augmente encore l'intérêt d'une couche de fonctionnalisation. L"invention permet la mise en œuvre de couches de fonctionnalisation sur des NEMS libérés par des techniques sans contact et collectives, par exemple par dépôt CVD, LPCVD, PECVD, ALD, épitaxie, porosification, etc. et de poursuivre ensuite par la fermeture du composant en rapportant un capot comportant une cavité de manière à former le canal fluidique. Ainsi les risques de collage par dépôt de la couche de fonctionnalisation par dépôt en phase liquide sont évités.

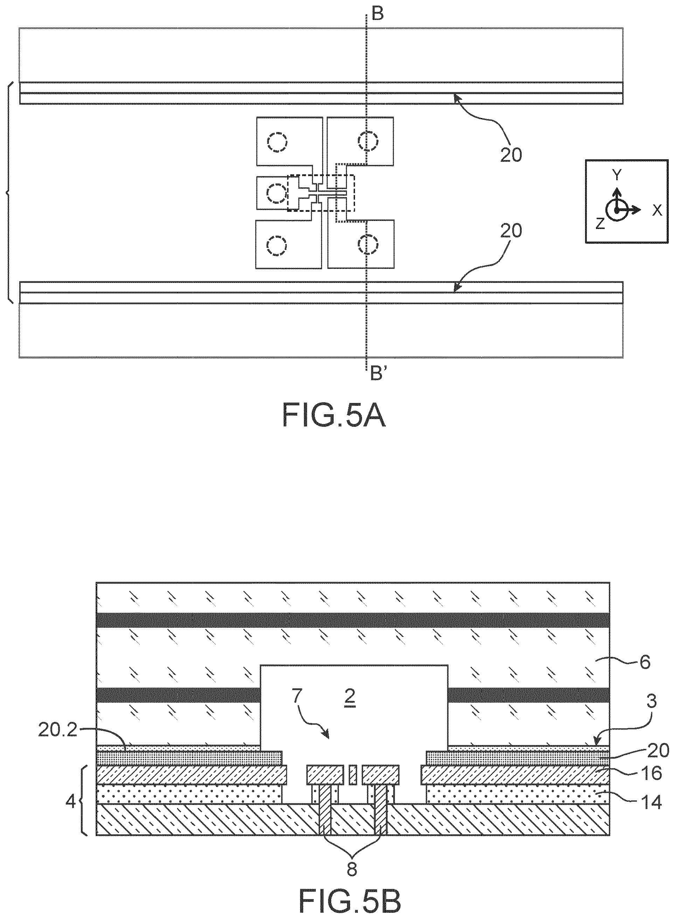

Sur les figures 5A et 5B, on peut voir un dispositif selon un exemple mettant en œuvre une couche supplémentaire 20 désignée "couche intermédiaire".

Selon un premier exemple représenté sur les figures 5A et 5B, la couche intermédiaire 20 est disposée au niveau de l'interface d'assemblage uniquement. Elle est interposée entre la couche 16 en semi-conducteur et le capot 6. La présence de la couche intermédiaire 20 à l'interface d'assemblage permet de faciliter l'assemblage. En effet, la couche intermédiaire peut présenter un état de surface permettant le scellement avec les faces de base du capot, par exemple un scellement par film sec, un scellement moléculaire, eutectique ou par thermocompression. La face apte au scellement peut présenter une certaine rugosité ou un certain relief qui permet néanmoins le scellement.

La couche intermédiaire 20 est présente au moins au niveau de l'interface de scellement entre la structure NEMS/MEMS 7 et le capot et est absente des zones sensibles de la structure NEMS/MEMS afin de laisser la ou les parties de la structure NEMS/MEMS suspendue en contact avec le milieu présent dans le canal fluidique.

Le matériau de la couche intermédiaire 20 est choisi de sorte à permettre l'obtention d'une face 20.2 suffisamment plane pour le scellement du capot. En fonction du type de scellement, l'état de surface de la face 20.2 obtenu directement après le dépôt de la couche intermédiaire peut être suffisant, ou une étape de planarisation est réalisée par exemple une étape de polissage mécano-chimique après la formation de la couche intermédiaire.

Le matériau de la couche intermédiaire est choisi apte à être gravé, par exemple en gravure anisotrope.

De préférence, le matériau de la couche intermédiaire 20 est choisi de sorte à présenter une bonne sélectivité à la gravure par rapport au procédé de libération des structures mécaniques et à ne pas générer de résidu lors de cette étape.

Le matériau de la couche intermédiaire est également choisi de sorte à être compatible avec les matériaux utilisés pour l'assemblage final du dispositif entre le substrat portant la structure NEMS/MEMS et le capot.

Dans le cas où une couche de fonctionnalisation est mise en œuvre,le matériau de la couche intermédiaire est choisi compatible avec celui de la couche de fonctionnalisation, en particulier de sorte à assurer une bonne adhérence de cette dernière.

Par exemple, le matériau de la couche intermédiaire est un matériau diélectrique, par exemple un oxyde de silicium, comme par exemple le du SiO₂ ou un oxyde formé à base de silane ou un oxyde formé à base de tetraethylorthosilicate (TEOS), un oxyde de silicium de type LTO (Low Temperature Oxyde) formé par dépôt chimique en phase vapeur basse pression ou LPCVD (Low Pressure Chemical Vapor Déposition) non dopé ou bien dopé au phosphore (PSG : phospho-Silicate-Glass) ou encore dopé au Bore et Phosphore (BPSG : Boro-Phospho-Silicate Glass), un oxyde déposé par dépôt chimique en phase vapeur assisté par plasma ou PECVD (Plasma Enhanced Chemical Vapor Déposition).

L'épaisseur de la couche intermédiaire est déterminée pour tenir compte de la consommation de matériau lors de la gravure de libération. Dans ce cas, l'épaisseur de la couche intermédiaire est par exemple de l'ordre de quelques µm.

En variante, la couche intermédiaire peut comporter deux couches. Une couche de matériau diélectrique formant la couche planarisante est déposée. La couche planarisante est par exemple un oxyde formé à base de silane SiH₄, ou encore d'un oxyde formé à base de tetraethylorthosilicate (TEOS). Une couche de protection, par exemple en Si amorphe, en nitrure de silicium, en métal (AISi, AlCu, ...), en oxyde d'Hafnium (HfO2), est ensuite déposée sur la couche planarisante, celle-ci accroissant la résistance à la gravure à l'acide fluorhydrique vapeur

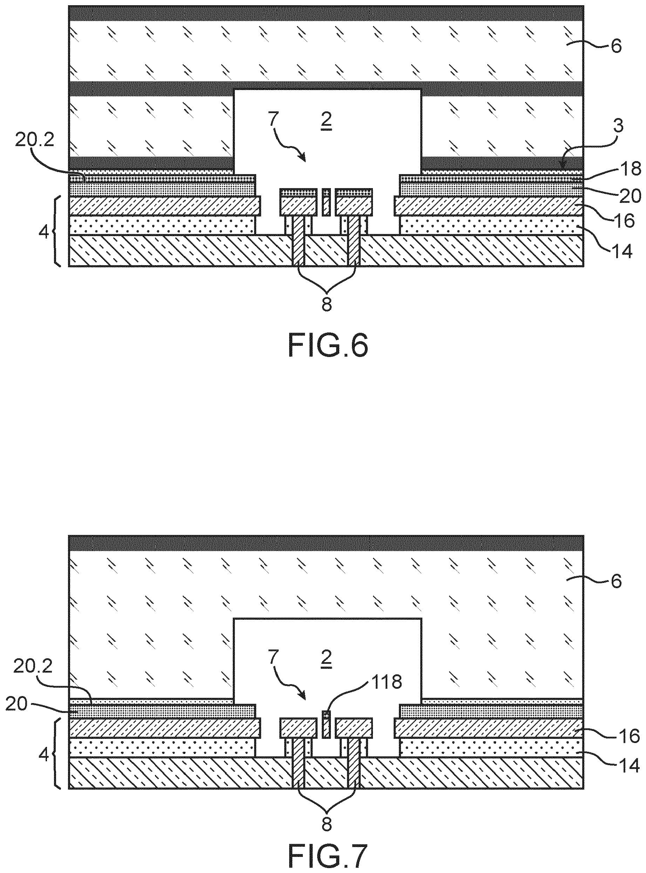

Sur la figure 6, on peut voir une variante de réalisation selon l'invention dans laquelle une couche de fonctionnalisation non localisée 18 est réalisée, elle se trouve alors sur la face 20.2 de la couche intermédiaire.

Sur la figure 7, on peut voir une variante de réalisation selon l'invention dans laquelle une couche de fonctionnalisation localisée 118 est réalisée, elle se trouve uniquement sur la partie sensible du NEMS.

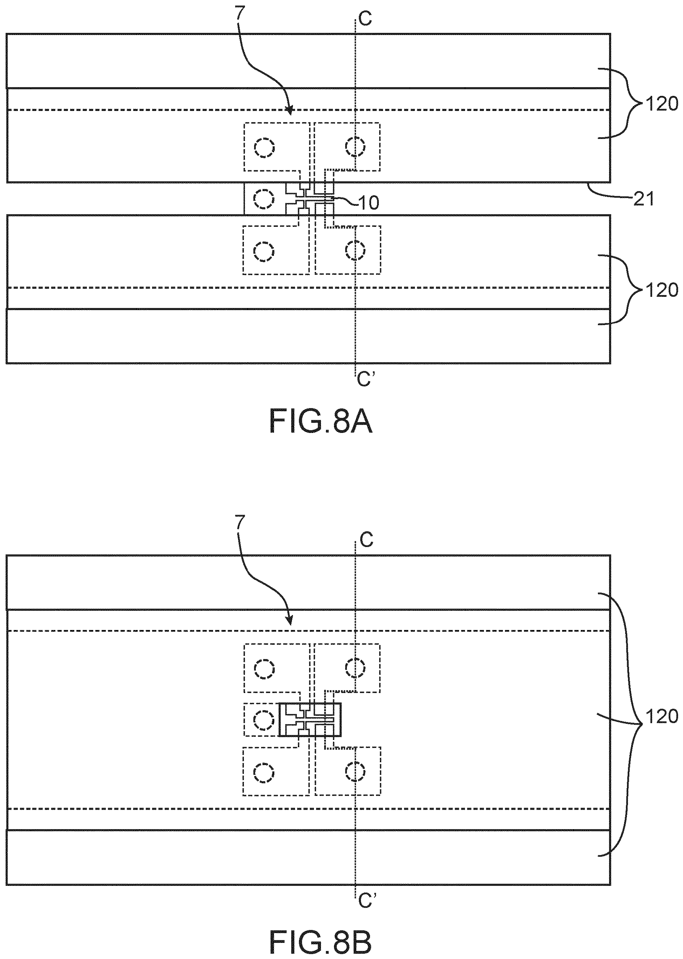

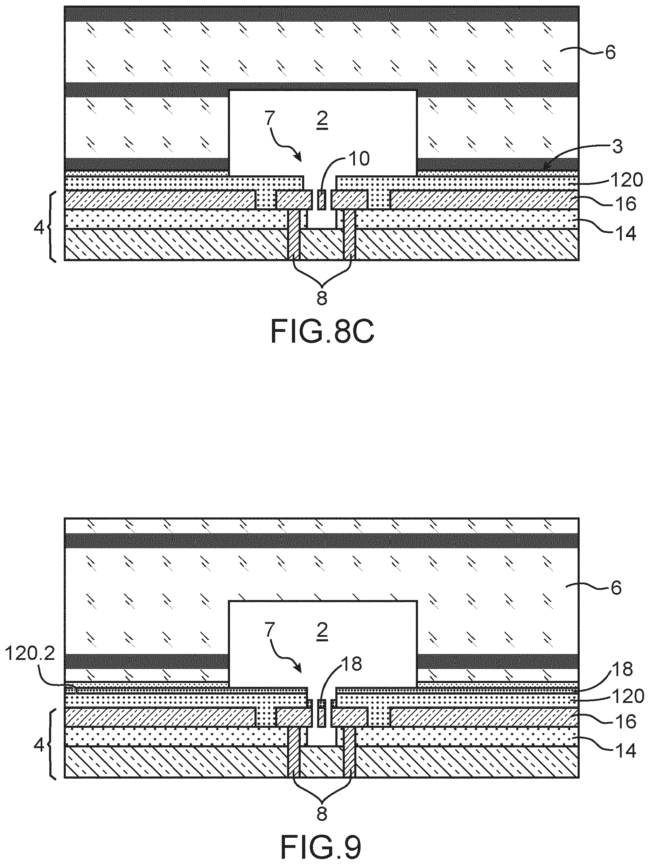

Sur les figures 8A, 8B et 8C, on peut voir un autre exemple de réalisation d'un dispositif mettant en œuvre une couche intermédiaire. Dans cet exemple, la couche intermédiaire 120 est située à l'interface de scellement et à l'intérieur du canal fluidique.

Sur la figure 8A, la couche intermédiaire délimite un canal 21 à l'intérieur du canal d'une largeur telle qu'elle laisse libre les parties sensibles de la structure NEMS.

Sur la figure 8B, la couche intermédiaire ne laisse libre que les parties sensibles de la structure NEMS, la couche intermédiaire étant présente en amont et en aval de la structure NEMS.

Dans cet exemple de réalisation, outre sa présence au niveau de l'interface de scellement, la couche intermédiaire encapsule les matériaux mis en œuvre au niveau du NEMS pour ne laisser accessible pour le fluide circulant dans le canal fluidique que la partie sensible du NEMS ou d'un réseau de NEMS.

Cette encapsulation présente l'avantage d'isoler les matériaux mis en jeu sur la partie NEMS qui, de par leur présence dans le canal fluidique 2, pourraient interagir avec le milieu en circulation dans le canal. C'est le cas par exemple avec les métaux ou diélectriques qui sont en général mis en œuvre dans le canal fluidique si la structure mécanique est formée d'un réseau dense de NEMS.

Un dispositif à canal fluidique dans lequel la couche intermédiaire ne recouvrirait pas entièrement la partie de la structure NEMS/MEMS non destinée à venir en contact avec le milieu environnant ne sort pas du cadre de la présente invention.

Ainsi, les interactions entre les matériaux mis en œuvre au niveau du NEMS et le milieu présent dans le canal fluidique sont évitées.

En outre, la couche intermédiaire forme une surface quasi-plane dans l'environnement des parties sensibles des NEMS, formant une quatrième face du canal fluidique.

Comme on peut le voir en particulier sur la figure 8C, la couche intermédiaire 120 est présente au-dessus de la couche 16 dans laquelle est réalisé le NEMS, qui est par exemple en semi-conducteur, au niveau des vias qui sont par exemple en métal. La présence de la couche intermédiaire renforce mécaniquement la structure en particulier vis-à-vis des contraintes mécaniques qui peuvent être engendrées au niveau des vias, par exemple du fait des différences de coefficients de dilatation thermique, entre le matériau des vias et le matériau environnant dans lequel ces vias sont formés. La fiabilité du dispositif est alors améliorée.

Sur la figure 9, on peut voir une variante de réalisation selon l'invention dans laquelle une couche de fonctionnalisation non localisée 18 est réalisée, elle se trouve alors sur la face 120.2 de la couche intermédiaire.

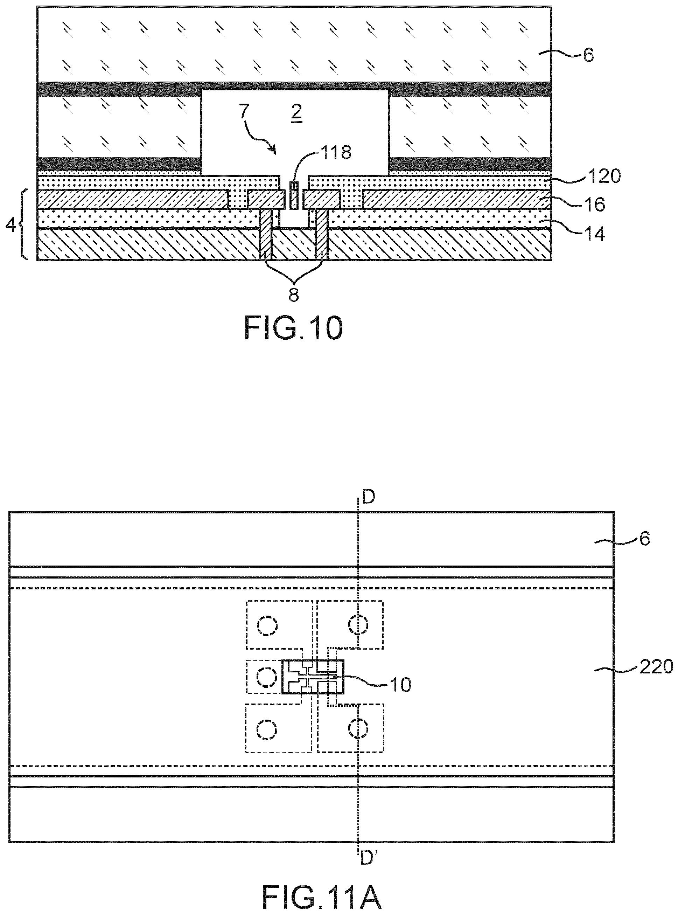

Sur la figure 10, on peut voir une variante de réalisation selon l'invention dans laquelle une couche de fonctionnalisation localisée 118 est réalisée, elle se trouve uniquement sur la partie sensible du NEMS.

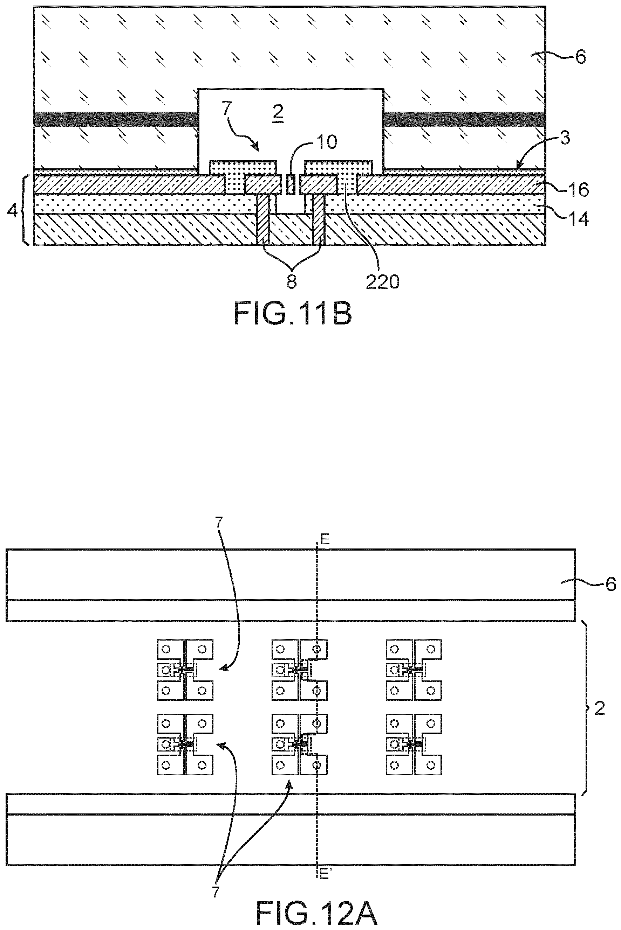

Sur les figures 11A et 11B, on peut voir un autre exemple de réalisation d'un dispositif mettant en œuvre une couche supplémentaire désignée couche d'encapsulation 220 qui n'est présente qu'à l'intérieur du canal fluidique et recouvre les matériaux mis en œuvre au niveau du NEMS.

La couche d'encapsulation 220 présente les mêmes avantages que ceux de la couche 120 sauf ceux relatifs au scellement.

De manière similaire aux variantes des figures 9 et 10, le dispositif des figures 11A et 11B peut comporter une couche de fonctionnalisation localisée sur les parties sensibles de la structure NEMS ou non localisée, elle se situerait alors à l'interface d'assemblage, sur la couche d'encapsulation 220 et les parties sensible de la structure NEMS.

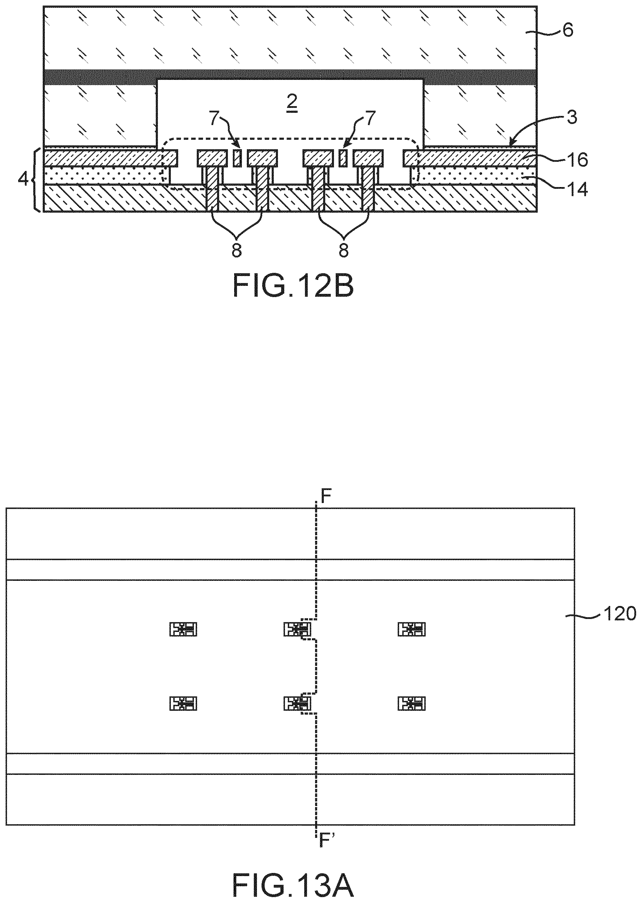

Sur les figures 12A et 12B, on peut voir un exemple de réalisation d'un dispositif mettant en œuvre une pluralité NEMS dans le canal fluidique. Les NEMS peuvent être connectés entre eux ou non. Un exemple de dispositif à NEMS interconnectés sera décrit ci-dessous.

Dans l'exemple représenté trois paires de NEMS sont alignés le long de l'axe X.

Sur les figures 12A et 12B, on peut voir un exemple de réalisation d'un dispositif à plusieurs structures NEMS 7, chacune de ces structures pouvant être reliée à un via. A noter que sur les figures 12A et 12B, il n'y a pas d'interconnexions métalliques du côté du canal fluidique, ni de couche intermédiaire représentée. Néanmoins, une telle couche intermédiaire peut être mise en œuvre dans les différentes configurations décrites auparavant.

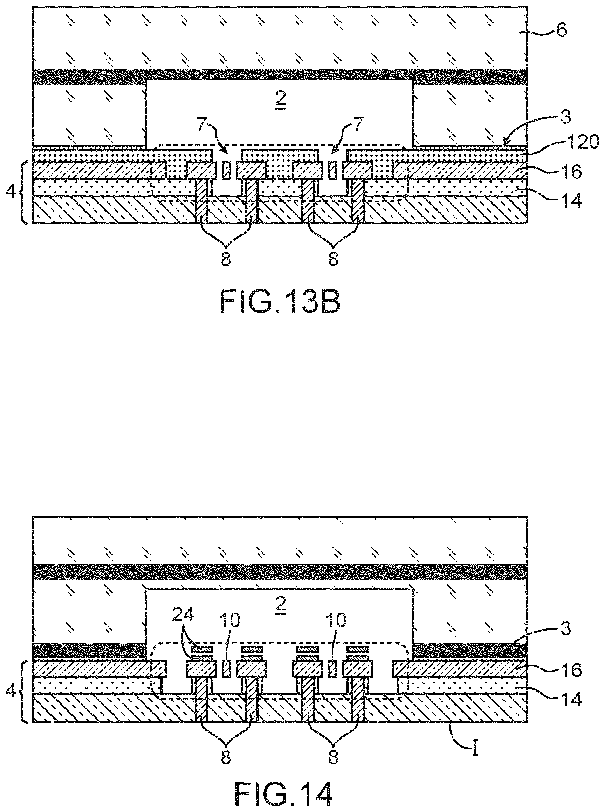

Par exemple, sur les figures 13A et 13B, une couche intermédiaire 120 est formée entre le capot et le substrat et dans le canal ne laissant libre que les parties sensibles des structures NEMS.

Sur la figure 14, on peut voir un dispositif comportant un réseau de NEMS interconnectés. Dans cet exemple, les interconnexions entre NEMS sont réalisées par des connexions conductrices, de préférence métalliques 24 formées sur les NEMS dans le canal fluidique.

Des lignes d'interconnexion 24 sont alors réalisées sur plusieurs niveaux de métal, deux dans l'exemple représenté, afin de connecter entre eux les NEMS formant le réseau de NEMS, qui se situe à l'intérieur du canal fluidique. Des interconnexions avec un ou plus de deux niveaux de métal ne sortent pas du cadre de la présente invention.

Cette configuration permet de préserver la planéité des surfaces entourant les NEMS, en particulier l'interface d'assemblage facilitant ainsi l'assemblage du capot et du substrat. Le ou les vias peuvent venir prendre contact sur une des lignes de connexion comme cela a été décrit ci-dessus.

En variante, les NEMS peuvent être reliés électriquement entre eux, soit directement par l'intermédiaire des motifs de connexion 8 et/ou par l'intermédiaire motifs d'interconnexions complémentaires au dispositif de l'invention, soit par des moyens intégrés au dispositif, par exemple par une couche de routage électrique formée sur la face arrière l, soit par des moyens extérieurs au dispositif, par exemple par une carte électronique ou un circuit intégré relié au dispositif par des techniques de flip-chip, de copper pillar, ou autres bien connues de l'homme du métier dans le domaine de l'intégration 3D.

En variante encore, les NEMS peuvent être reliés entre eux par l'intermédiaire de lignes d'interconnexions réalisées dans le matériau de la couche 16 et/ou par l'intermédiaire d'une ou de plusieurs couches métalliques réalisées dans les plans parallèles à la couche 16. Dans ce dernier cas, les interconnexions métalliques peuvent être isolées électriquement les unes des autres par de l'air ou bien un ou des matériaux diélectriques.

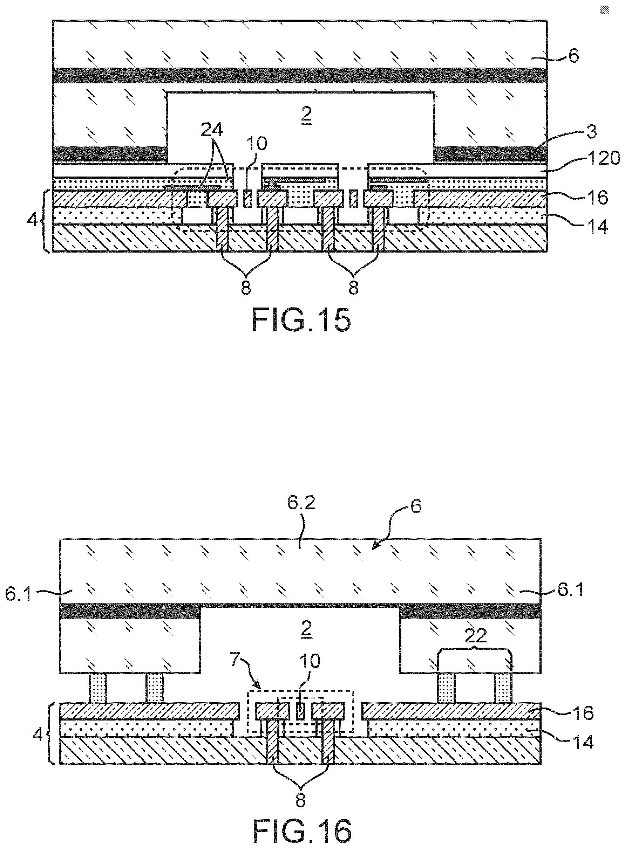

Sur la figure 15, on peut voir une variante du dispositif de la figure 14 dans laquelle une couche intermédiaire 120 est mise en œuvre. De manière très avantageuse, les interconnexions électriques sont encapsulées par la couche intermédiaire 120 en matériau isolant électrique, par exemple en oxyde de silicium ne laissant accessibles que les parties sensibles. Cette encapsulation permet d'isoler les matériaux des interconnexions avec le fluide circulant dans le canal et ainsi éviter des réactions non désirées avec celui-ci. Cette couche intermédiaire forme également une quatrième face du canal fluidique.

Les différents niveaux de métallisation sont encapsulés partiellement dans la couche 120 isolante électrique par exemple en oxyde de silicium.

Cette encapsulation par la couche intermédiaire est particulièrement intéressante à mettre en œuvre dans le cas de NEMS qui sont connectés entre eux par des pistes conductrices en semi-conducteur ou en métal avec éventuellement plusieurs niveaux d'interconnexions, l'isolation électrique entre les niveaux étant assurée par des couches de diélectriques, et l'ensemble étant localisé dans le canal fluidique.

Sur les figures 16 à 18, on peut voir représenter des dispositifs dans lesquels l'assemblage est réalisé au moyen d'un film de résine sec 22 ou DFR (Dry Film Resist en anglais).

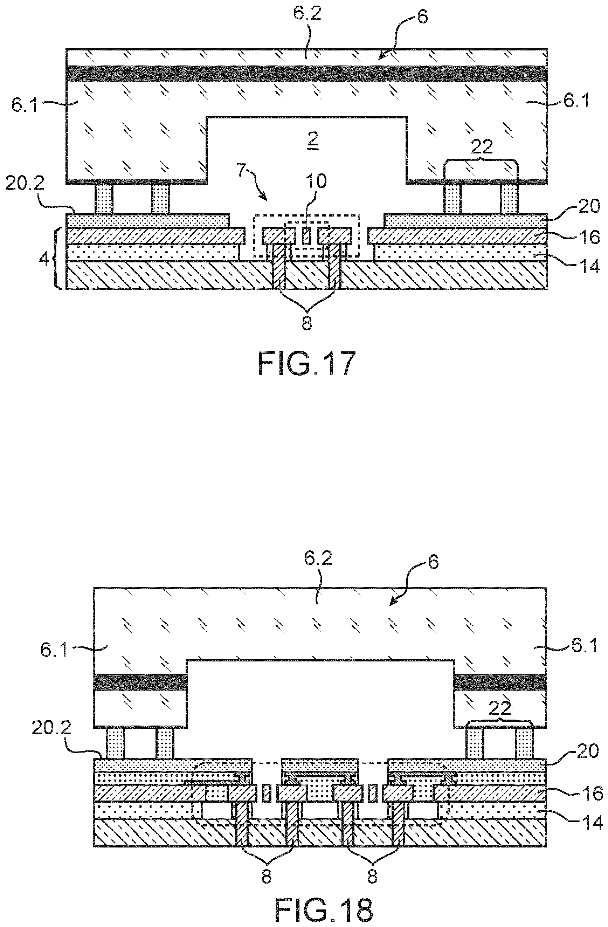

Par exemple, un film mince de résine est appliqué par laminage sur la face inférieure du capot 6 destinée à venir en contact de la couche 16 (figure 16) ou la couche intermédiaire 20 (figures 17 et 18) et est structuré par photolithographie et développement. L'ensemble capot et film de résine, est reporté et scellé sur le substrat.

Dans l'exemple représenté sur les figures 16 à 18, le film mince 22 se présente sous la forme de deux cordons parallèles, présentant sensiblement la même surface de scellement. Ces cordons sont obtenus après insolation et développement du film sec.

Le film sec est par exemple une résine avec des bases epoxy, phenol, acrylic ou silicone par exemple.

Le film sec a par exemple une épaisseur comprise entre quelques µm à plusieurs dizaines de µm, voire quelques centaines de µm avec un multicouche de film sec, avantageusement quelques µm seulement.

Le scellement au moyen d'un film sec présente les avantages suivants :
- ce scellement peut avoir lieu à une température relativement basse, généralement en dessous de 250°C voire à température ambiante, ce qui est compatible avec l'existence de pistes métalliques. En effet, dans le cas de pistes en aluminium, la température maximale est 400°C.
- ce scellement est compatible avec un grand nombre de matériaux,
- le film sec peut être réalisé sur le capot malgré la forte topologie due au canal fluidique déjà formé, ce qui permet de ne pas effectuer des opérations de type photolithographie sur la structure NEMS/MEMS car celle-ci contient déjà des structures mécaniques libérées,
- ce scellement par film sec présente l'avantage d'être moins exigeant en termes d'état de surface nécessaire (planéité, rugosité, présence de particules) à l'interface de scellement que des scellements de type moléculaire ou eutectique ou même par thermo-compression. Ainsi la mise en œuvre d'un film sec peut permettre le scellement sans effectuer de polissage mécano-chimique préalable de la face du substrat sur laquelle le scellement est réalisé par exemple la face 20.2 de la couche intermédiaire (figures 17 et 18), son état de surface directement après dépôt pouvant être suffisant.

Cette caractéristique permet avantageusement de réaliser ce scellement en présence d'une couche de fonctionnalisation à l'interface d'assemblage. En outre, la température d'un tel scellement est compatible avec la présence d'une couche de fonctionnalisation déposée ou formée elle-même à basse température, par exemple en polymère, etc.
- Ce type de film offre en outre la possibilité de travailler avec des épaisseurs importantes, par exemple de l'ordre de plusieurs centaines de µm mais également des épaisseurs de quelques 10µm; voire quelques µm, une épaisseur faible permettant de limiter l'épaisseur du matériau du film sec pouvant interagir avec le milieu environnant.
- De plus, ce type de film présente une bonne stabilité thermique.
- En outre, ce scellement étant compatible avec un grand nombre de matériaux, une grande liberté est offerte pour le choix de la ou des couches de fonctionnalisation qui peuvent être mises en œuvre. On peut alors envisager de mettre en œuvre des couches de fonctionnalisation de natures et/ou d'épaisseurs différentes sur les parties NEMS et Capot. Ceci est particulièrement intéressant dans le cas où le capot forme une colonne de chromatographie gazeuse. Dans ce cas le capot pourra recevoir une fonctionnalisation apte à remplir la fonction de séparation des analytes du mélange à analyser alors que le NEMS pourra recevoir une autre fonctionnalisation apte à optimiser ses performances en détection.

Dans le cas où une couche de fonctionnalisation est mise en œuvre,le scellement est avantageusement réalisé par film sec.

Nous allons maintenant décrire des exemples de procédé de réalisation de dispositifs à canal fluidique selon la présente invention.

Le procédé qui va être décrit permet la réalisation de plusieurs NEMS simultanément dans un canal fluidique alignés le long de l'axe longitudinal, un seul étant visible. Il sera compris que le procédé permet la réalisation de plusieurs dispositifs simultanément avec un ou plusieurs NEMS, les dispositifs étant ensuite séparés à la fin du procédé de fabrication.

Dans une première phase, le substrat muni de la structure NEMS/MEMS est réalisé à partir d'un substrat silicium sur isolant ou SOl (Silicon en Insulator en anglais) par exemple. Alternativement, il peut être utilisé tout substrat comportant une couche dans laquelle serait réalisée la structure NEMS/MEMS, cette couche étant formée sur une couche sacrificielle permettant par sa gravure une libération de la structure NEMS/MEMS. Le matériau de la couche dans laquelle est réalisée la structure NEMS/MEMS peut être un semi-conducteur monocristallin ou polycristallin par exemple du Si, Ge, SiGe, SiC, GAAs, InAs, InP... La couche sacrificielle peut être présente sur l'ensemble du substrat ou bien être localisée seulement à certains endroits où seront réalisés les NEMS.

On peut envisager que la structure NEMS/MEMS comporte une fonction optique de sorte à comporter des microsystèmes opto-électro-mécaniques (ou MOEMS, pour Micro-Opto-Electro-Mechanical Systems en anglais) et/ou d'intégrer une partie électronique intégrée, CMOS, etc.

Le premier exemple de procédé qui va être décrit permet de réaliser un dispositif selon l'invention comportant une couche intermédiaire et une couche de fonctionnalisation localisée avec un niveau d'interconnexions au niveau des NEMS comme par exemple représenté sur la figure 7.

Le substrat SOI comporte une couche de matériau isolant 28, par exemple de l'oxyde de silicium et une couche de silicium 30 dans laquelle va être formée la structure NEMS.

Lors d'une première étape, le silicium de la couche 30 est dopé. Pour cela a lieu la formation d'une couche d'oxyde de protection, sur la couche 30 dopée, par exemple il s'agit d'un oxyde thermique, puis une étape d'implantation, puis de recuit et de désoxydation par retrait de la couche d'oxyde.

Le dopage peut être réalisé pleine plaque ou avec des masquages, par exemple au moyen d'une résine si l'on souhaite localiser des zones avec des dopages différents. Par exemple, on peut envisager un dopage de type P (Bore par exemple) ou N (Phosphore par exemple) moyen à modéré (quelques 10¹⁸ à quelques 10¹⁹ at/cm³) au niveau de la zone NEMS selon par exemple que l'on souhaite optimiser le coefficient de gauge piézorésistif et/ou les bruits, et un dopage fort (quelques 10²⁰ at/cm³) au niveau des plots de contact destinés à accueillir le métal des vias sur leur face inférieure, de façon à assurer un bon contact ohmique.

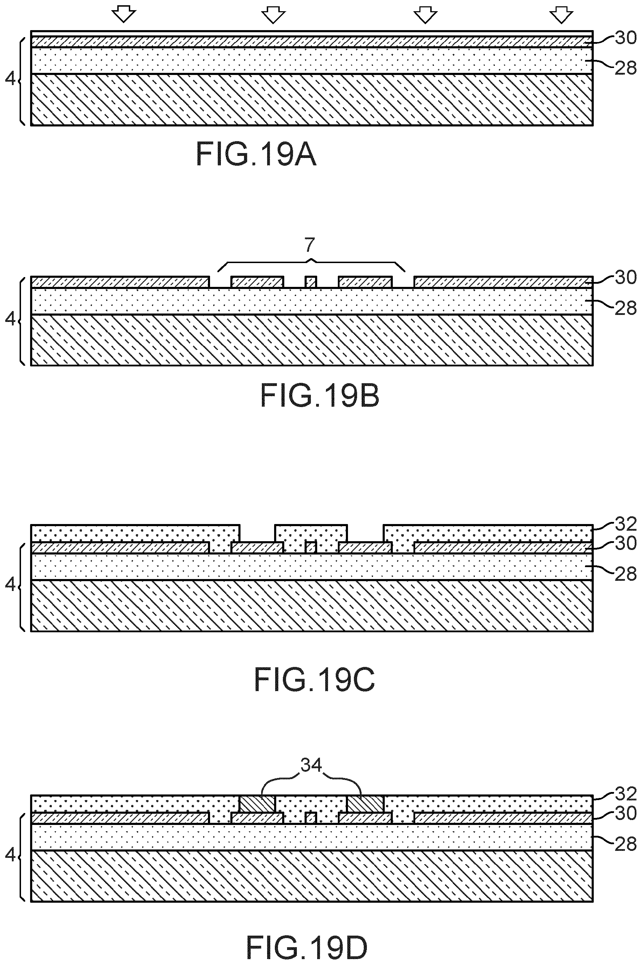

L'élément ainsi obtenu est représenté sur la figure 19A.

Lors d'une étape suivante, les structures NEMS et les plots de contact électriques sont définis.

Pour cela, une photolithographie et ensuite une gravure anisotrope de la couche de silicium 30 sont réalisées de manière connue.

Ensuite a lieu une étape de décapage ou stripping sur le silicium et sur la couche d'oxyde 28 pour retirer la couche de résine photosensible.

L'élément ainsi obtenu est représenté sur la figure 19B. Sur la figure 19B qui est une vue en coupe un seul NEMS est visible mais de préférence la structure comporte une pluralité de NEMS dans la direction X. La structure pourrait également comporter plusieurs NEMS dans une direction perpendiculaire à la direction X.

Lors des étapes suivantes, les lignes d'interconnexion en métal sont réalisées. Pour cela, un dépôt d'une couche diélectrique 32 sur la couche 30 structurée a ensuite lieu, il s'agit par exemple d'oxyde formé à base de silane SiH₄ dont l'épaisseur est supérieure à la topologie de la couche de silicium 30 structurée.

Une étape de polissage mécano-chimique ou CMP a ensuite lieu afin de rendre plane la surface de la couche 32. De préférence, préalablement une photolithographie de type "contremasque" et une gravure partielle de la couche 32 de la hauteur de la topologie à rattraper sont effectuées, ce qui facilite l'étape de polissage et permet de réduire sa durée.

Lors d'une étape suivante, la couche 32 est ouverte par photolithographie et gravure pour atteindre la couche de silicium 30 et préparer la réalisation des plots de contacts électriques et/ou des lignes d'interconnexions entre NEMS.

L'élément ainsi obtenu est représenté sur la figure 19C.

Lors d'une étape suivante, une couche de métal 34 est déposée par exemple en AISi, celui-ci présentant l'avantage d'offrir une bonne résistance à la gravure par acide fluorhydrique vapeur qui a lieu pour libérer les structures mécaniques. Les épaisseurs de couches formées sont adaptées pour faciliter la planarisation ultérieure.

Lors d'une étape suivante, a lieu un polissage mécano-chimique.

L'élément ainsi obtenu est représenté sur la figure 19D.

Dans l'exemple représenté, la couche 32 est conservée. En variante elle pourrait être retirée, avantageusement gravée sélectivement par rapport au métal des lignes d'interconnexion, afin de conserver les lignes d'interconnexion et/ou de métallisation des plots de contact. Elle peut être entièrement retirée ou n'être retirée que partiellement, par exemple dans les zones destinées à l'assemblage. Les étapes de réalisation des plots de contact et/ou des lignes d'interconnexion peuvent être répétées plusieurs fois afin de réaliser plusieurs niveaux d'interconnexions métalliques. Ces étapes peuvent également permettre de réaliser des lignes d'interconnexions électriques entre différents NEMS sur un ou plusieurs niveaux. Les lignes d'interconnexion sont alors isolées les unes des autre par le matériau des couches 32.

Les étapes suivantes décrivent la réalisation de la couche intermédiaire 20.

Dans l'exemple représenté, la couche intermédiaire 20 comporte deux couches. Une couche de matériau diélectrique 35 est déposée, par exemple un oxyde de silicium formé à base de silane SiH₄, ou encore un oxyde de silicium formé à base de tetraethylorthosilicate (TEOS). Une couche de protection 36, par exemple en Si amorphe, en nitrure de silicium, en métal (AISi, AlCu, ...), en oxyde d'Hafnium (HfO2), est ensuite déposée sur la couche 35, celle-ci accroissant la résistance à la gravure à l'acide fluorhydrique vapeur utilisé pour la libération des NEMS.

Dans le cas d'une couche intermédiaire en un seul matériau, son épaisseur est déterminée de sorte qu'elle soit apte à protéger en particulier les lignes de connexion lors de l'étape finale de libération des structures mécaniques, i.e. son épaisseur est choisie suffisante pour tenir compte de sa diminution du fait de la gravure de libération afin qu'elle recouvre encore les lignes de connexion. Comme mentionné précédemment, l'épaisseur de la couche intermédiaire dans ce cas peut être par exemple de l'ordre de quelques µm.

Dans cet exemple, la couche intermédiaire 20 est formée sur des lignes d'interconnexions métalliques et/ou des plots de contact électriques, mais elle pourrait être mise en œuvre directement sur la couche NEMS (avec ou sans lignes d'interconnexions métalliques ou plots de contact électriques), etc... Il est à noter que la couche 32 aurait pu être enlevée après la formation des lignes d'interconnexion, la couche intermédiaire 20 aurait alors été formée directement sur celles-ci.

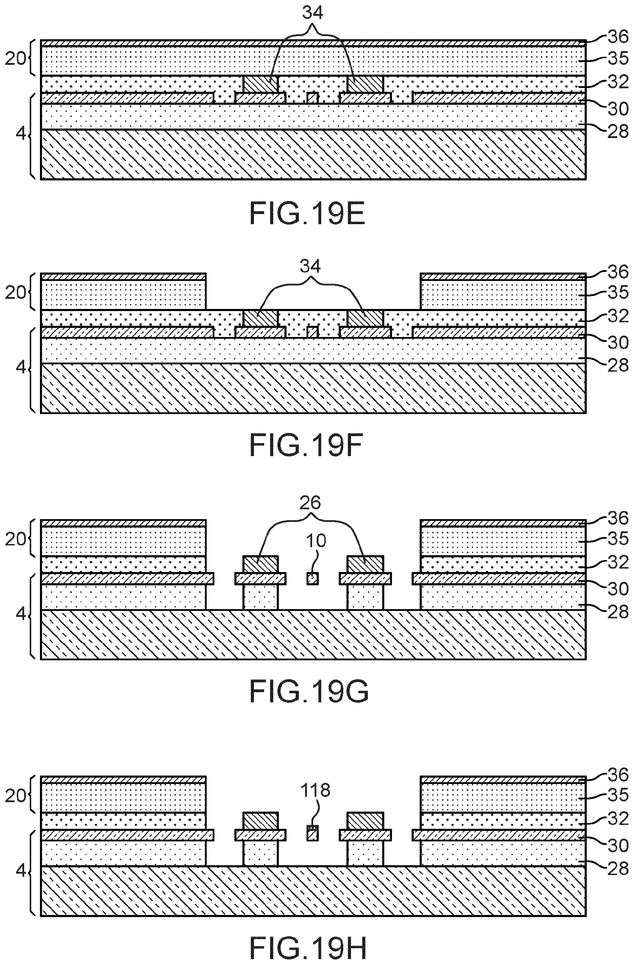

L'élément ainsi obtenu est représenté sur la figure 19E.

Une étape de polissage, par exemple par CMP, de la couche 32 préalablement au dépôt de la couche 20 peut avoir lieu.

Lors d'une étape suivante, la couche intermédiaire est gravée de sorte à atteindre la structure NEMS/MEMS à libérer. La couche de Si amorphe 36 et la couche 35 sont gravées, la couche 32 peut également être partiellement ou totalement gravée. Par exemple on pourra utiliser une gravure plasma à base de SF₆ pour la couche de Si amorphe et une gravure plasma à base de CHF₃ pour la gravure de l'oxyde de silicium formant la couche intermédiaire.

La couche Intermédiaire 20 peut être gravée de différentes manières pour réaliser les différents dispositifs décrits précédemment. On peut ainsi la graver uniquement au-dessus des parties sensibles en protégeant tout le reste de la surface afin que la couche intermédiaire soit à l'interface d'assemblage et dans le canal fluidique, ou alors uniquement à l'interface d'assemblage ou encore uniquement dans le canal fluidique, dans ce cas elle a uniquement une fonction d'encapsulation.

La gravure de la couche intermédiaire 20 est adaptée pour préserver à la fois les interconnexions métalliques et la structure NEMS/MEMS en matériau semi-conducteur. Ainsi, la forme des ouvertures est déterminée par exemple par photolithogravure de façon à tenir compte de la longueur de libération des structures mécaniques qui intervient en fin de procédé « NEMS », car cette étape peut provoquer une gravure latérale non désirée de la couche planarisante de la couche intermédiaire 20, ce qui, si elle n'était pas maitrisée, pourrait conduire à dégager des zones non désirées telles que des interconnexions métalliques, zones sous l'interface de scellement avec le capot. De plus, la gravure de l'ouverture dans la couche intermédiaire est de préférence stoppée au niveau de la couche métallique au-dessus du semi-conducteur, avant d'atteindre le semi-conducteur, afin de ne pas endommager la couche de semi-conducteur qui constitue la structure mécanique.

L'élément ainsi obtenu est représenté sur la figure 19F.

Lors d'une étape suivante, la structure NEMS/MEMS, en particulier la ou les partie mobile 10 est/sont libérée(s). La libération a lieu par exemple par gravure isotrope au moyen d'acide fluorhydrique vapeur des matériaux diélectriques entourant la structure NEMS, il s'agit des couches 28 et 32. La couche 28 peut être gravée totalement ou partiellement. Du fait de la présence de la couche de protection 36, la couche 35 est protégée, son épaisseur ne diminue pas.

L'élément ainsi obtenu est représenté sur la figure 19G.

Sur la figure 19H, est représenté l'élément de la figure 19G comportant une couche de fonctionnalisation localisée 118 sur la partie suspendue 10 du NEMS. En variante, cette couche pourrait être non localisée.

Cette couche de fonctionnalisation peut être réalisée de différentes manières par dépôts en phase liquide ou gazeuse. De manière préférentielle, des techniques de dépôt en phase gaz par exemple par dépôt chimique en phase vapeur ou CVD (Chemical Vapor Deposition en terminologie anglo-saxonne), par LPCVD, par PECVD, par dépôt de couches minces atomiques ou ALD (Atomic Layer Déposition), etc. sont utilisées. Des techniques d'épitaxie et/ou de porosification de matériaux et/ou de type évaporation peuvent également être mises en œuvre. Ces techniques sont préférables aux techniques par voie liquide, type spray ou spotting (dépôt de gouttes), car elles permettent d'éviter la mise en œuvre de phases liquides en présence de structures NEMS libérées. Néanmoins, ces dernières techniques peuvent également être utilisées, par exemple si les structures NEMS/MEMS sont suffisamment rigides.

Les matériaux déposés formant le ou les couches de fonctionnalisation peuvent être par exemple des matériaux de type polymères, des diélectriques, des semi-conducteurs ou autres matériaux poreux, des métaux, etc.

Dans le cas d'un dépôt localisé, il peut être utilisé des techniques de masquage mécanique (pochoir), des techniques de lift-off connues dans les procédés de réalisation des microsystèmes, ou bien encore des techniques de spotting consistant à déposer des gouttes de solution liquide localement, etc.

Sur la figure 19H, la couche de fonctionnalisation est représentée uniquement en surface du NEMS. Préférentiellement, la couche de fonctionnalisation entoure le NEMS, l'épaisseur de la couche de fonctionnalisation n'étant pas forcément uniforme tout autour de la structure mécanique. Ce dépôt est obtenu en mettant en œuvre des techniques de dépôt conforme, par exemple par CVD.

Un exemple d'étapes de réalisation du capot 6 va maintenant être décrit à partir d'un substrat 38 poli sur ses deux faces, par exemple en silicium, en verre, en quartz..., désigné substrat capot 38.

Tout d'abord, des marques (non représentées) sont définies puis gravées en face arrière 38.1 et en face avant 38.2 du substrat, ces marques servant à l'alignement entre le substrat NEMS et le capot lors de leur scellement.

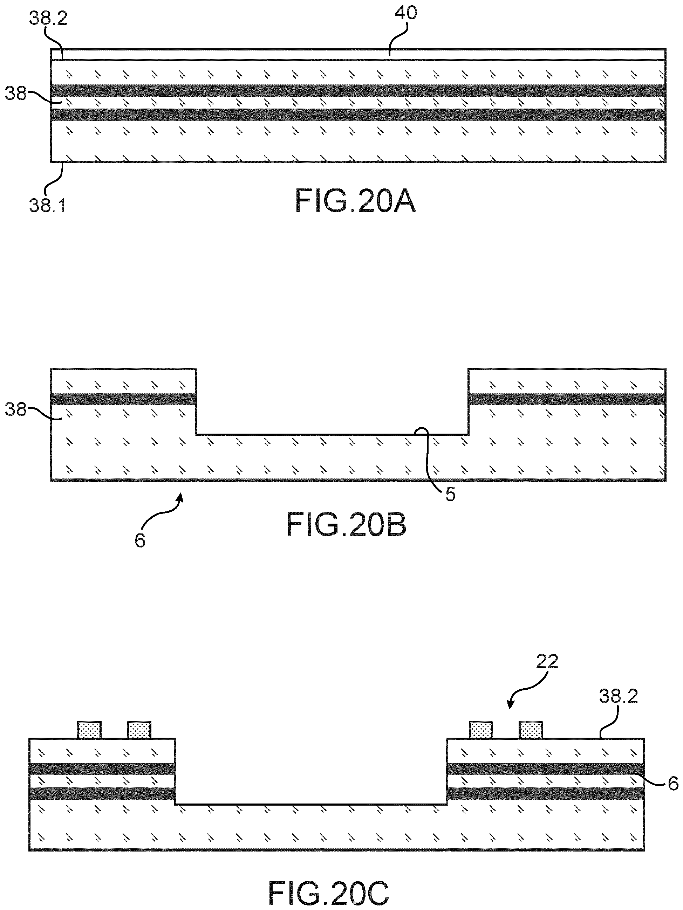

Lors d'une étape suivante, un dépôt d'un masque dur, par exemple d'un masque d'oxyde de silicium de quelques µm d'épaisseur, est effectué sur la face avant 38.2 du substrat 38 (figure 20A). Une photolithographie et une gravure du masque 40 ont lieu pour définir les cavités.

Ensuite, le substrat capot 38 est gravé par exemple par gravure ionique réactive profonde ou DRIE (Deep reactive ionic etching en anglais) avec par exemple un procédé de type « Bosch » consistant en une succession d'étapes de gravure avec un plasma SF₆ et de passivation avec un plasma C₄F₈ formant ainsi les cavités qui délimiteront les canaux fluidiques. La profondeur de la gravure est par exemple de l'ordre de quelques centaines de µm.

Le masque dur peut ensuite être retiré par exemple par gravure humide de type HF.

L'élément ainsi obtenu est représenté sur la figure 20B.

Deux étapes de lithogravures peuvent être réalisées si l'on souhaite obtenir plusieurs profondeurs de gravure, par exemple une première profondeur pour le canal fluidique et une deuxième profondeur pour réaliser la ou les entrées et la ou les sorties du canal fluidique.

Comme pour les NEMS, on peut prévoir de fonctionnaliser le canal fluidique en déposant des matériaux sur les faces intérieures de la gravure réalisée dans le capot, les matériaux peuvent être ceux de la couche de fonctionnalisation de la structure NEMS ou d'autres matériaux.

Nous allons maintenant décrire un exemple préférentiel d'assemblage du capot sur le substrat, par un film sec de résine. De manière préférée et comme cela va être décrit, le film sec est formé sur le capot.

Lors d'une étape suivante, le capot 6 est préparé pour un scellement sur la structure NEMS/MEMS au moyen d'un film sec. La surface de scellement du capot est préparée de manière à assurer une bonne adhérence du film sec sur le capot.

Le film sec 22 est ensuite fixé sur la face avant 38.2 du substrat capot 38, cette fixation est avantageusement obtenue par laminage. Ce laminage permet de travailler malgré la forte topologie due à l'existence des canaux fluidiques de ce côté du substrat.

Lors d'une étape suivante, une lithographie et un développement sont réalisés pour structurer le film sec, celui-ci présente alors des cordons le long des cavités gravées dans le capot. Il peut s'agir d'un cordon large, ou alors de préférence de plusieurs cordons étroits parallèles les uns aux autres comme cela est représenté sur la figure 20C. Dans ce dernier cas, par exemple les cordons et les espaces entre les cordons peuvent être de quelque µm à quelques dizaines de micromètres.

De préférence, les cordons présentent une structure régulière et une surface de scellement proche sur l'ensemble de la structure à sceller de sorte à assurer un écrasement homogène du film sec avec une pression raisonnable lors de l'étape de scellement.

L'élément ainsi obtenu est représenté sur la figure 20C, le substrat capot 38 est alors prêt à être scellé sur le substrat de la structure NEMS/MEMS 4.

En variante, comme cela a été décrit plus haut, d'autres techniques de scellements peuvent être mises en œuvre pour assembler le capot et le substrat. Dans ce cas d'autres étapes de préparation peuvent être mises en œuvre,par exemple des nettoyages particuliers. Ensuite des techniques de scellement connues de l'homme du métier peuvent être mises en œuvre,comme par exemple un scellement moléculaire ou encore des scellements eutectiques, des scellements métalliques, par exemple par thermocompression, certains de ces scellements pouvant nécessiter la formation préalable de cordons métalliques.

Lors d'une étape suivante, le capot 6 et le substrat 4 comportant la structure NEMS/MEMS sont scellés. Le scellement est réalisé sur un équipement de scellement qui permet de contrôler la température et la pression appliquée entre le capot et le substrat à sceller. Des traitements de surface connus dans l'état de l'art peuvent éventuellement être effectués pour optimiser l'énergie de collage.

Tout d'abord, le substrat 4 et le capot 6 sont alignés au moyen des marques réalisées précédemment sur les substrats.

Puis une pression est appliquée entre le substrat 4 et le capot 6, ainsi qu'une température.

Par exemple la pression appliquée est de l'ordre de quelques kN à quelques dizaines de kN, et par exemple la température est comprise entre 100°C et 200°C.

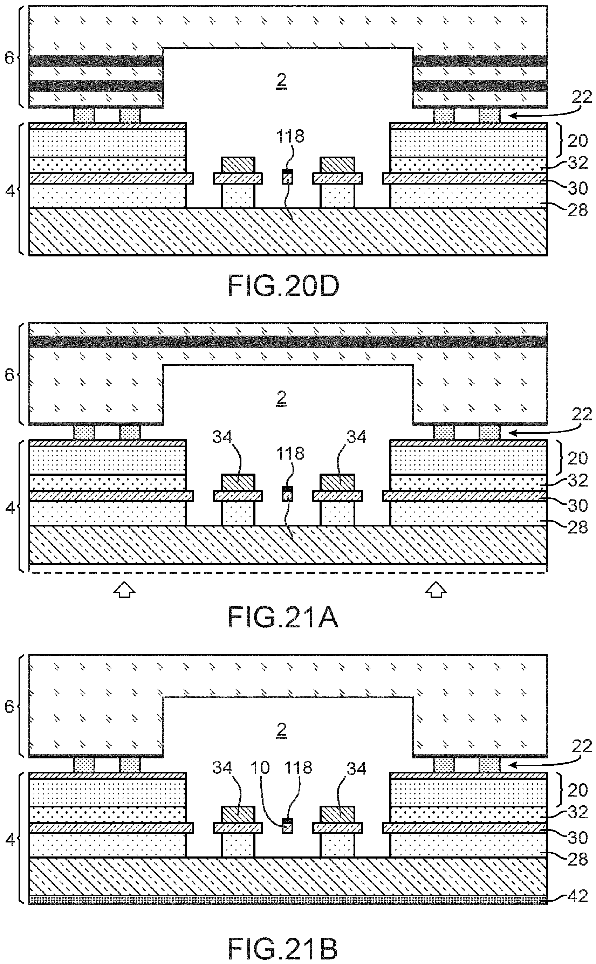

Le substrat 4 et le capot 6 sont alors assemblés. Le canal fluidique est alors étanche au niveau des bords latéraux. L'élément ainsi obtenu et représenté sur la figure 20D.

Typiquement, un assemblage tel que celui de la figure 20D est réalisé à partir de substrats circulaires utilisés en microélectronique.

Les étapes de réalisation des vias vont maintenant être décrites.

De préférence, lors d'une étape le substrat en silicium en face arrière est aminci par exemple par grinding et ensuite par polissage mécano-chimique. En amincissant le substrat en face arrière, la profondeur des vias est avantageusement limitée et les opérations de remplissage des cavités avec le métal sont facilitées.

L'épaisseur restante du substrat est telle qu'on conserve une épaisseur suffisante pour conserver un ensemble non fragilisé. Avantageusement le substrat en face arrière a une épaisseur restante de l'ordre de 15 µm à 50 µm, pour des vias de quelques µm de largeur, par exemple 5 µm. Cette largeur permet de disposer d'une densité importante de contacts. Avec les facteurs de forme de l'ordre de 2 à 10, les profondeurs de vias sont alors d'environ 10 à 50 µm. Ces dimensions permettent à la fois une densité importante de vias *et préservent* une épaisseur de couche du substrat restante après amincissement suffisante pour que la zone du substrat formant le fond inférieur du canal fluidique résiste aux opérations d'amincissement.

Le canal fluidique peut par exemple avoir quelques dizaines de µm à quelques centaines de µm, typiquement 100µm de profondeur pour 100µm de largeur.

De manière très avantageuse, l'étape d'amincissement a lieu après l'étape de scellement du capot et du substrat NEMS, de sorte que le capot serve de « poignée » lors des opérations d'amincissement du substrat NEMS. Ainsi on peut obtenir un amincissement suffisant du substrat pour atteindre les densités de vias souhaitées tout en conservant une tenue mécanique suffisante.

En variante, l'étape d'amincissement peut être réalisée par gravure chimique, gravure plasma...

L'élément ainsi obtenu est représenté sur la figure 21A.

Lors d'une étape suivante, une couche de matériau diélectrique 42 est formée en face arrière, par exemple d'une épaisseur de quelques µm. La couche 42 est par exemple oxyde de silicium déposé par PECVD par exemple. Cette couche 42 a pour objectif d'isoler les vias d'une partie de redistribution, également appelée RDL pour "Redistribution Layer" en terminologie anglo-saxonne, qui sera combinée lors d'une étape ultérieure afin de relier le dispositif comportant des vias à un circuit électronique extérieur. L'élément ainsi obtenu est représenté sur la figure 21B.

Lors d'une étape suivante, les vias sont réalisés dans le substrat aminci.

Pour cela, la couche 42 est structurée, par exemple par lithographie et gravure anisotrope, par exemple par plasma CHF₃. Ensuite le substrat de silicium 27 est gravée par exemple par DRIE plasma SF₆ et passivation C₄F₈ et la couche sacrificielle 28 est également gravée, par exemple par plasma CHF₃, avec arrêt de gravure sur la couche NEMS 30. Les trous ainsi formés sont désignés 44.

De manière préférée, on effectue une première gravure profonde avec arrêt dans la couche d'oxyde 28 puis on effectue une gravure fine pour atteindre la couche 30 et éviter de l'endommager.

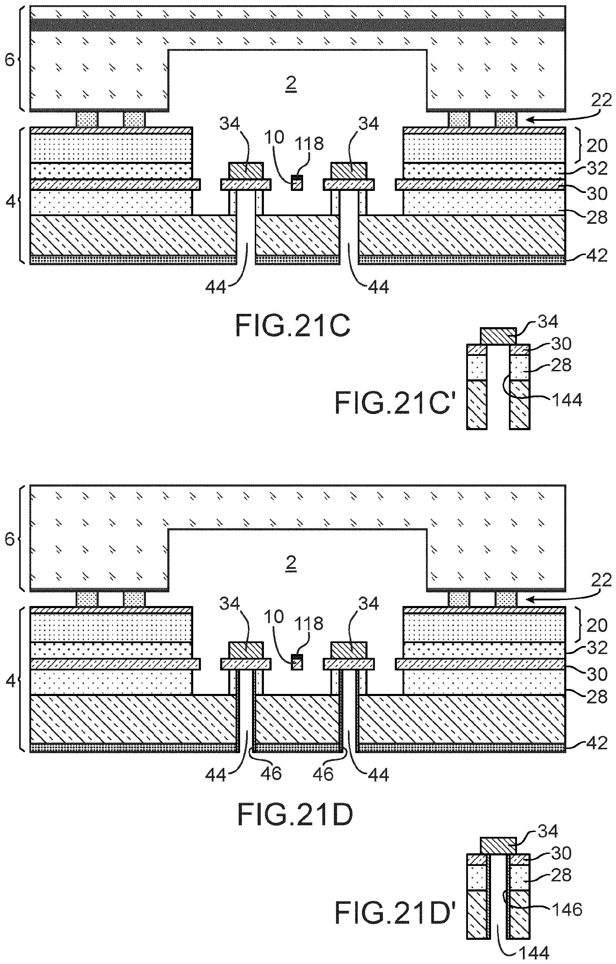

L'élément ainsi obtenu est représenté sur la figure 21C.

En variante, la gravure s'arrête sur les plots de contact et/ou les lignes d'interconnexion (figure 21C') afin de réaliser un contact métal/métal entre le via et le plot ou la ligne d'interconnexion au lieu d'un contact métal/silicium, la couche 30 sera alors également gravée lors de la gravure du via.

La résine est ensuite retirée.

Les procédés de gravure sont choisis avantageusement afin d'éviter les sous-gravures et les effets de scalloping le long des parois.

Les dimensions des trous sont par exemple de l'ordre de 2 µm à 10µm de large et de 10 µm à 100µm de profondeur. Ces dimensions permettent des étapes de gravure, de nettoyage des fonds de via, de conformité des matériaux de remplissage, etc...

En variante, la gravure pourrait être réalisée par perçage laser, mais l'arrêt sur la couche 30 peut être plus complexe.

Lors d'une étape suivante, une couche en matériau d'isolation électrique 46 est formée sur la face intérieure des trous 44 par exemple par dépôt le matériau présentant avantageusement une très bonne conformité, par exemple il s'agit d'un diélectrique SiO₂ formé par SACVD (Sub-atmospheric Chemical Vapor Deposition en terminologie anglo-saxonne) de quelques centaines de nm, pour réaliser l'isolation électrique latérale des trous 44.

D'autres matériaux d'isolation électrique peuvent être mis en œuvre, par exemple d'autres types de SiO₂ et autres diélectriques, par exemple un polymère.

L'élément ainsi obtenu est représenté sur la figure 21D.

Sur la figure 21D', les trous 144 sont recouverts d'une couche en matériau d'isolation électrique 146.

En variante, la gravure décrite en relation avec la figure 21B s'arrête dans la couche sacrificielle 28 ce qui réduit les risques de détérioration de la couche NEMS, qui est fine au regard de l'épaisseur gravée dans le substrat. Ensuite, la couche d'isolation électrique est déposée et la gravure est reprise pour atteindre la couche NEMS 30.

Ensuite une étape de nettoyage et de préparation de surface en fond de via a lieu.

Une couche barrière (non représentée) est ensuite formée en fond de trou et sur les parois latérales des trous, par exemple en TiN, Ti, Ta, TaN..., par exemple de quelques dizaines de 10nm. Celle-ci est par exemple déposée en pulvérisation ou CVD....

Lors d'une étape suivante, une couche de germination est formée, par exemple en cuivre par PVD et/ou CDV et/ou pulvérisation afin de préparer le remplissage du via par un métal. Cette couche a par exemple une épaisseur comprise entre quelques dizaines de nm et quelques centaines de nm.

Lors d'une étape suivante, les trous sont remplis avec un matériau conducteur électrique 48, de sorte à former des vias. De préférence, le matériau conducteur électrique est métallique, par exemple en Cu, en W, en Si polysilicium fortement dopé par exemple.

Le remplissage est réalisé par exemple par dépôt électrochimique ou ECD (ElectroChemical Déposition). Un recuit thermique peut ensuite avoir lieu. Le remplissage peut également être réalisé par CVD ou PVD, ces techniques permettant d'assurer une bonne conformité du remplissage.

Une étape de polissage mécano-chimique a ensuite pour planariser l'ensemble et enlever le surplus de Cu.

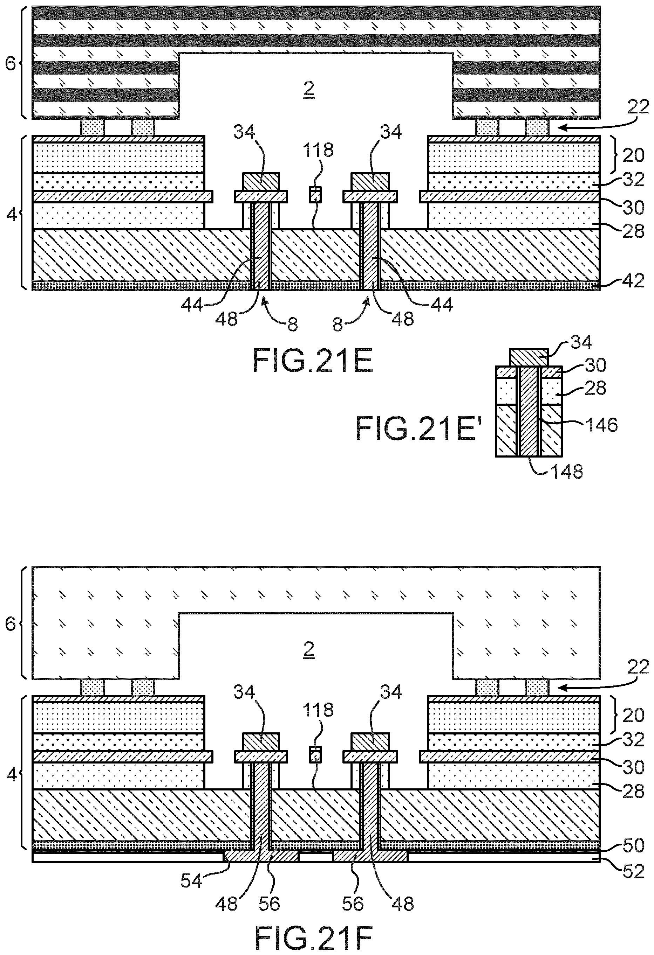

L'élément ainsi obtenu est représenté sur la figure 21E, le matériau conducteur électrique du via est en contact avec le silicium du NEMS, par exemple il s'agit de contact Cu/Si ou W/Si. Sur la figure 21E', le matériau conducteur 148 est en contact avec le métal présent à la surface du plot de contact ou de la ligne d'interconnexion, par exemple il s'agit de contact Cu/Cu ou Cu/AISi.

Par exemple une couche de distribution ou RDL peut être formée sur la surface où débouchent les vias, par exemple en mettant en œuvre les étapes suivantes:
Par exemple, une fine couche 50 de nitrure SiN est formée en face arrière, par exemple ayant une épaisseur de l'ordre de 50 nm, ainsi qu'une couche d'oxyde d'isolation RDL 52 d'épaisseur de quelques centaines de nm sur la couche 50.

Lors d'une étape suivante, une lithographie sur la couche 52 et une gravure de l'oxyde RDL 52 ont lieu avec arrêt sur la couche 52, de sorte à former des lignes 54 gravées dans l'oxyde RDL.

Lors d'une étape suivante, la résine est retirée.

A lieu ensuite l'élimination du SiN dans lignes gravées 54 au droit des vias afin d'atteindre les vias. Les lignes sont ensuite nettoyées.

Lors d'une étape suivante, une métallisation du fond des lignes a lieu, par exemple avec une couche de TiN et de cuivre. Cette métallisation est par exemple réalisée par PVD sur une épaisseur de quelques centaines de nm, puis les lignes sont remplies de cuivre 56 déposé par exemple par ECD, par exemple sur une épaisseur de 1µm. Ont ensuite lieu un recuit et un polissage mécano-chimique.

L'élément ainsi obtenu est représenté sur la figure 21F.

La couche RDL permet de distribuer les contacts TSV et préparer le dispositif à la connectique avec l'extérieur par exemple avec un circuit intégré. De plus cette couche peut permettre de réaliser des tests électriques pour trier les puces si besoin avant de les assembler avec le circuit intégré, ce qui permet d'optimiser les coûts en tenant compte des aspects rendements si ceux-ci sont différents pour les dispositifs de l'invention et les circuits intégrés.

Alternativement, le dispositif pourra être préparé de manière connue pour une connexion avec des circuits intégrés (puces ou plaques).

On pourra ainsi réaliser des opérations de connexions des dispositifs à des circuits intégrés grâce à des opérations de type report de puces ou report de wafer, en reliant les vias du dispositif de l'invention à un des niveaux métalliques du(des) circuit(s) intégré(s), avantageusement par l'intermédiaire de la couche RDL.

Cette opération peut être effectuée de différentes manières en reportant un wafer sur un autre wafer (« Wafer to Wafer »), ou bien des puces sur un wafer (« Die to Wafer ») ou encore des puces sur des puces (« Die to Die »). Dans le cas de report de puces, les puces formant circuit intégré peuvent être reportées sur des puces ou wafers de dispositifs de l'invention ou bien le contraire.

Les différentes techniques développées pour les technologies 3D notamment sont envisageables, telles que les billes fusibles, les scellements Au-Au, les scellements polymères avec motifs métalliques en configuration damascène, etc.

Ces techniques peuvent demander de réaliser des opérations de préparation sur le dispositif de l'invention et/ou sur la partie circuit intégré, par exemple :
- en procédant à des nettoyages particuliers des couches métalliques, par exemple pour des scellements directs Cu-Cu
- en formant une couche RDL comme décrit précédemment
- en formant des motifs de métal (ex « Copper Pillar » pour scellement Cu-Cu) à la surface du dispositif avant d'appliquer des techniques de scellement métalmétal tel que Cu, Au,..., des techniques de scellement avec des matériaux fusibles tels que InAu, CuSn...), des techniques de scellement avec des conducteurs eutectiques ...
- en formant des billes fusibles pour appliquer des techniques de flip-chip, AuSn etc.

Dans le procédé qui a été décrit ci-dessus, une couche intermédiaire 20 a été réalisée sur le substrat comportant les NEMS avant le scellement au capot.

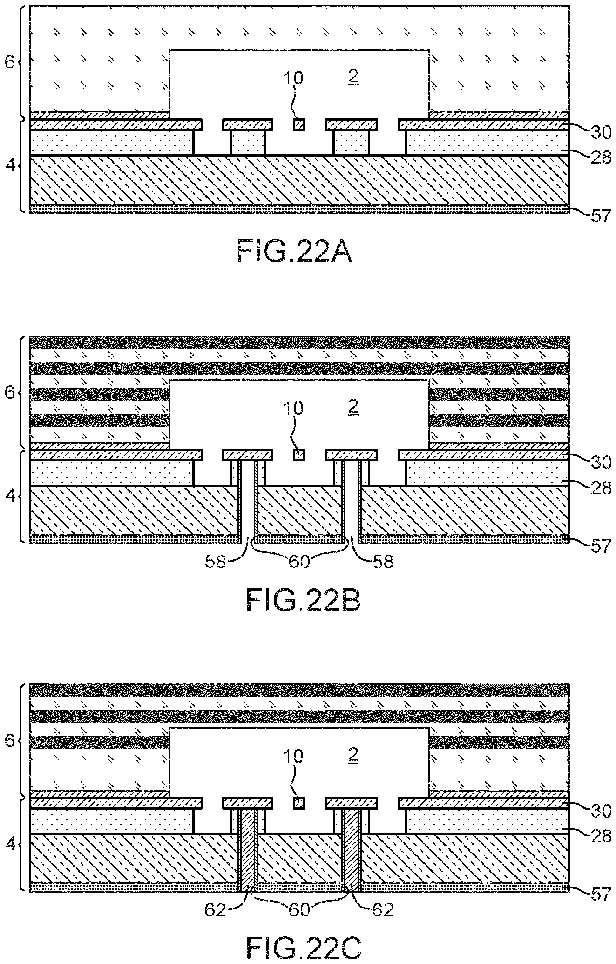

Mais le dispositif selon l'invention peut ne pas comporter de couche intermédiaire. Sur les figures 22A à 22E, on peut voir les étapes de réalisation des vias dans un dispositif sans couche intermédiaire.

Les étapes de réalisation du substrat comportant le NEMS sont similaires aux étapes représentées sur les figures 19A et 19B. Dans cet exemple il n'y a pas de réalisation de lignes d'interconnexion.

Les étapes de réalisation du capot sont similaires aux étapes représentées sur les figures 20A et 20B

Le scellement est réalisé de manière similaire au scellement de l'étape représentée sur la figure 20C. Il s'agit de préférence d'un scellement par film sec, mais il peut s'agir alternativement d'un scellement eutectique, d'un scellement moléculaire, d'un scellement métallique par thermocompression...

La réalisation des vias va maintenant être décrite.

La réalisation des vias est similaire à celle des étapes représentées sur les figures 21C à 21E.

D'une part le substrat 4 est aminci en face arrière par exemple par grinding puis CMP, afin d'atteindre une épaisseur par exemple comprise entre 15µm et 50 µm.

Lors d'une étape suivante, une couche 57 d'un matériau diélectrique est formée en face arrière.

L'élément ainsi obtenu est représenté sur la figure 22A.

Lord d'une étape suivante, des trous 58 sont gravés dans le substrat suivant la méthode décrite en relation avec la figure 21C. La gravure peut s'arrêter sur la couche NEMS 30.

Lors d'une étape suivante, une couche de matériau d'isolation électrique 60, par exemple du SiO₂ SACVD est déposée sur la face intérieure des trous suivant la méthode décrite en relation avec la figure 21D.

L'élément ainsi obtenu est représenté sur la figure 22B.

Lors d'une étape suivante, les vias sont formés en remplissant les trous avec un matériau conducteur électrique 62, de préférence un métal, suivant la méthode décrite en relation avec la figure 21E.

L'élément ainsi obtenu est représenté sur la figure 22C.

Nous allons maintenant décrire un procédé de réalisation d'un dispositif comportant une couche intermédiaire mais sans ligne d'interconnexion dans le canal fluidique.

Les premières étapes de réalisation du substrat NEMS sont similaires aux étapes de figures 19A et 19B.

Lors d'une étape suivante, une couche intermédiaire 20 est formée sur la couche 30. Elle être formée de plusieurs matériaux, par exemple elle peut comporter en surface une couche résistant à la gravure de libération du NEMS, par exemple elle peut être en silicium amorphe résistant à l'acide fluorhydrique vapeur.

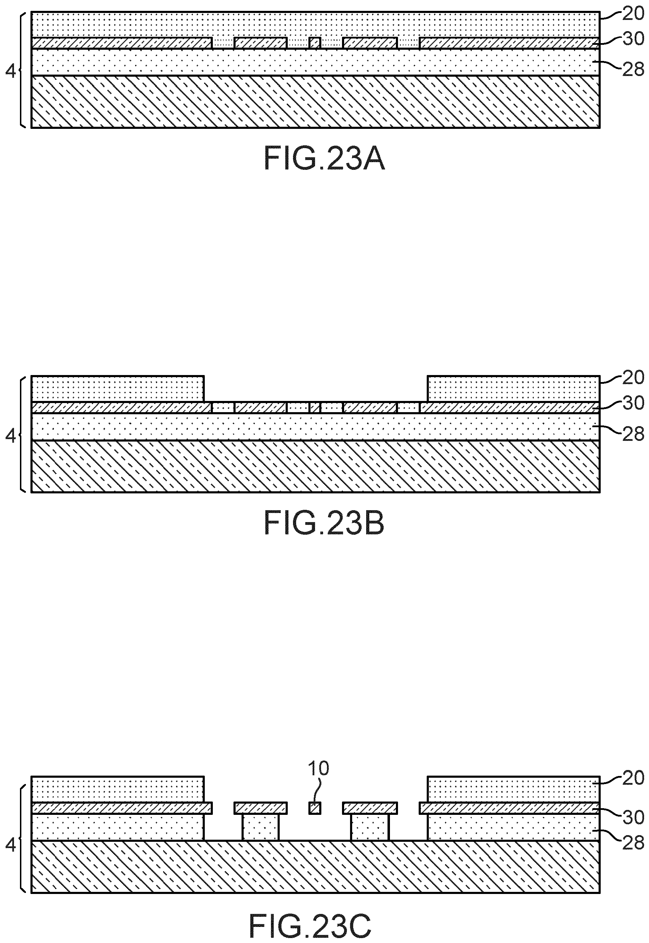

L'élément ainsi obtenu est représenté sur la figure 23A.

Lors d'une étape suivante, la couche intermédiaire 20 est structurée afin d'accéder à la zone de la ou des structures NEMS à libérer. Pour cela, une lithographie et une gravure de la couche intermédiaire 20 ont lieu. Dans cet exemple, la couche intermédiaire 20 est conservée dans la zone d'assemblage. Elle pourrait être structurée autrement comme cela a été décrit ci-dessus, par exemple uniquement au-dessus des parties sensibles en protégeant le reste de la surface ou alors de graver au niveau de l'interface d'assemblage pour retirer la couche intermédiaire dans cette zone et ne la conserver que dans le canal fluidique. Ensuite la structure NEMS est libérée par exemple par de l'acide fluorhydrique vapeur.

L'élément ainsi obtenu est représenté sur la figure 23C.

Les étapes de réalisation du capot sont similaires aux étapes représentées sur les figures 20A et 20B

Le scellement est réalisé de manière similaire au scellement de l'étape représentée sur la figure 20C. Il s'agit de préférence d'un scellement par film sec, mais il peut s'agir alternativement d'un scellement eutectique, d'un scellement moléculaire, par thermocompression...

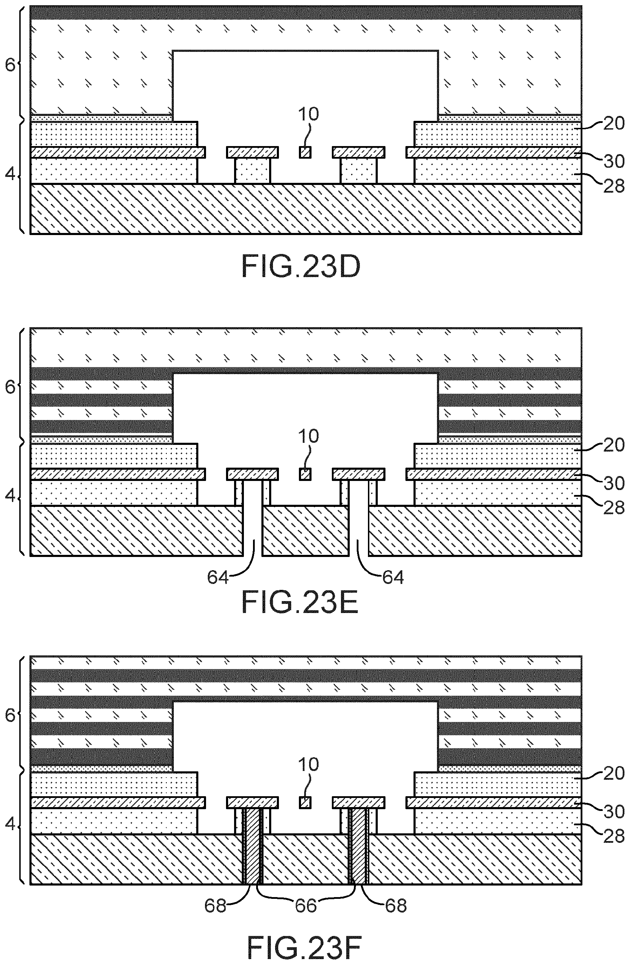

Dans cette réalisation le scellement se fait entre la couche intermédiaire 20 et le capot 6. L'élément ainsi obtenu est représenté sur la figure 23D.

La réalisation des vias va maintenant être décrite

La réalisation des vias est similaire à celle des étapes représentées sur les figures 21B à 21E.

D'une part le substrat 4 est aminci en face arrière par exemple par grinding puis CMP, afin d'atteindre une épaisseur par exemple comprise entre 15 µm et 50 µm.

Lors d'une étape suivante, une couche 62 d'un matériau diélectrique est formée en face arrière.

Lord d'une étape suivante, des trous 64 sont gravés dans le substrat suivant la méthode décrite en relation avec la figure 21C. La gravure peut s'arrêter sur la couche NEMS 30 (figure 23E), ou dans la couche sacrificielle 28.

Lors d'une étape suivante, une couche de matériau d'isolation électrique 66, par exemple du SiO₂ SACVD est déposée sur la face intérieure des trous suivant la méthode décrite en relation avec la figure 21D.

Lors d'une étape suivante les vias sont formés en remplissant les trous avec un matériau conducteur électrique 38, de préférence un métal.

L'élément ainsi obtenu est représenté sur la figure 23F.

Dans les exemples de procédé décrits ci-dessus, les vias sont réalisés après le scellement du capot sur le substrat NEMS et après libération des NEMS. Mais les dispositifs selon l'invention pourraient être réalisés avec des procédés dans lesquels les vias seraient réalisés avant libération des NEMS et avant le scellement du capot sur le substrat NEMS ou après la libération des NEMS et avant le scellement entre le capot et le substrat NEMS.

Comme cela a été mentionné ci-dessus, il est possible de fabriquer collectivement des dispositifs sur des substrats par exemple de silicium, l'ensemble formé comportant plusieurs canaux parallèles Les dispositifs sont ensuite séparés par des opérations de clivage et/ou sciage par exemple. On souhaite diviser chaque canal pour former plusieurs dispositifs et séparer les canaux les unes des autres.

Il est souhaitable de ne pas polluer les canaux fluidiques pendant les étapes de séparation. Pour cela et de manière très avantageuse, tout d'abord on réalise au niveau des entrée-sortie des canaux fluidiques, des traits de découpe partiels dans l'épaisseur des substrats NEMS et Capot orthogonaux à l'axe des aux canaux fluidiques mais qui n'atteignent pas ces canaux, les traits de découpe définissent alors des plans perpendiculaire à l'axe du canal.; ensuite une opération de clivage a lieu qui permet la séparation finale des dispositifs le long des plans définies par les traits de découpe.

Il est à noter que les plans sont sécants avec l'axe du canal mais pas nécessairement perpendiculaire à cet axe.

Pour ce qui concerne la séparation dans les directions parallèles aux canaux fluidiques, des opérations de sciages classiques peuvent être mises en œuvre.

Selon les approches retenues dans le cas d'une liaison des dispositifs avec des circuits intégrés (WTW, DTW, DTD), les étapes de séparation des puces de dispositifs pourront être faites avant ou après scellement avec les circuits intégrés.

Grâce à l'invention, il est possible de réaliser un dispositif à canal fluidique comportant une ou plusieurs structures mécaniques suspendues dans le canal, évitant ainsi la formation de via dans le capot et/ou au niveau de l'interface de scellement et de lignes d'interconnexion latérales rendant plus complexe la réalisation de l'étanchéité entre le capot et le substrat NEMS.

De plus, l'invention permet de réaliser facilement des réseaux de structures mécaniques en permettant une interconnexion électrique dense et complexe au plus près des structures mécaniques avec éventuellement plusieurs niveaux de métal. L'invention peut permettre également d'encapsuler toutes les structures et couches présentes dans le canal exceptées les structures sensibles avec une couche d'encapsulation. Enfin elle permet la mise en œuvre de fonctionnalisation en cours de procédé sur des structures mécaniques suspendues.

## Revendications

1. Dispositif comportant un substrat comprenant au moins une structure microélectronique et/ou nanoélectronique (NEMS) comportant au moins une partie sensible et un canal fluidique (2) défini entre ledit substrat et un capot (6), ledit canal fluidique (2) comportant au moins deux ouvertures pour assurer une circulation dans ledit canal, ladite structure microélectronique et/ou nanoélectronique étant située à l'intérieur du canal fluidique, ledit capot étant assemblé avec le substrat au niveau d'une interface d'assemblage, ledit dispositif comportant au moins une connexion électrique entre ladite structure microélectronique et/ou nanoélectronique et l'extérieur du canal fluidique (2), ladite connexion électrique (8) étant formée par un via réalisé à travers le substrat (4) à l'aplomb de ladite structure microélectronique et/ou nanoélectronique et en contact électrique avec ladite structure microélectronique et/ou nanoélectronique, ledit dispositif comportant également une couche de fonctionnalisation (18, 118) recouvrant au moins une partie de la partie sensible de la structure microélectronique et/ou nanoélectronique.

2. Dispositif selon la revendication 1, dans lequel le via est en contact électrique avec la structure microélectronique et/ou nanoélectronique par l'intermédiaire d'un plot de contact situé dans le canal fluidique.

3. Dispositif selon la revendication 1 ou 2, comportant également une couche intermédiaire (120, 220) située au moins en partie dans le canal fluidique et située sous une partie de la couche de fonctionnalisation (18,118), ladite couche intermédiaire (120, 220) recouvrant, dans le canal fluidique (2), au moins en partie la structure microélectronique et/ou nanoélectronique à l'exception de sa partie sensible.

4. Dispositif selon la revendication 3, dans lequel la couche intermédiaire (20) est une couche d'encapsulation et/ou dans lequel la couche intermédiaire (20, 120, 220) comporte un matériau isolant électrique, tel qu'un oxyde de silicium, ou un nitrure de silicium, la couche intermédiaire (120, 220) isolant avantageusement électriquement les lignes d'interconnexion.

5. Dispositif selon l'une des revendications 1 à 4, comportant plusieurs structures microélectroniques et/ou nanoélectroniques interconnectées dans ledit canal fluidique, les structures microélectronique et/ou nanoélectronique étant avantageusement interconnectées entre elles par des lignes d'interconnexion disposées dans le canal fluidique.

6. Dispositif selon l'une des revendications 1 à 5, comportant un film sec de scellement (22) interposé entre le substrat (4) et le capot, le film sec de scellement (22) comportant avantageusement plusieurs cordons, ou ledit dispositif comportant au moins une couche de matériau interposée entre le substrat et le capot (6) réalisant un scellement eutectique ou métallique ou par thermo-compression, ou par sérigraphie ou un scellement moléculaire ou un scellement par frittage de verre.

7. Dispositif selon l'une des revendications 1 à 6, dans lequel le canal forme une microcolonne de chromatographie en phase gazeuse.

8. Procédé de réalisation d'au moins un dispositif selon l'une des revendications 1 à 7, comportant les étapes :
a) réalisation d'au moins une structure microélectronique et/ou nanoélectronique sur un substrat,
b) réalisation d'un capot (6) comportant un canal fluidique (2), dans un substrat capot,
d) scellement du capot (6) et du substrat de sorte que la structure microélectronique et/ou nanoélectronique soit située dans le canal fluidique (2),
e) réalisation d'au moins un via dans le substrat à l'aplomb de la structure microélectronique et/ou nanoélectronique,
l'étape e) pouvant avoir lieu après l'étape d) ou avant l'étape d), le procédé comportant également entre l'étape b) et l'étape d) :
c) réalisation d'une couche de fonctionnalisation (18,118) à l'intérieur du canal fluidique (2) sur la structure microélectronique et/ou nanoélectronique, la couche de fonctionnalisation pouvant être également sur les parois du capot (6), ladite couche de fonctionnalisation (18, 118) étant réalisée avant le scellement.

9. Procédé selon la revendication 8, dans lequel la réalisation du via comporte au moins
- L'étape de réalisation d'un trou dans une partie au moins du substrat,
- L'étape de remplissage de tout ou partie dudit trou avec un matériau conducteur électrique,
ledit procédé comportant avantageusement préalablement à la réalisation du au moins un via et après l'étape d), une étape d'amincissement du substrat.

10. procédé selon la revendication 9, comportant préalablement à l'étape de remplissage dudit trou avec un matériau conducteur électrique, une étape de dépôt sur la surface interne du trou d'un matériau isolant électrique.

11. Procédé selon la revendication 9 ou 10, dans lequel la réalisation du trou est obtenue par une gravure profonde puis par une gravure fine et/ou dans lequel, la partie sensible de la structure microélectronique et/ou nanoélectronique étant suspendue, celle-ci étant libérée avant l'étape d).

12. Procédé selon l'une des revendications 8 à 11, comportant une étape de formation d'une couche intermédiaire sur le substrat après l'étape a) dans une zone telle qu'elle comporte au moins une partie située dans le canal fluidique après l'étape e) ou une étape de formation d'une couche intermédiaire sur le substrat après l'étape a) dans une zone telle qu'elle se situe uniquement à l'interface d'assemblage après l'étape e), la couche de fonctionnalisation étant avantageusement formée sur la couche intermédiaire.

13. Procédé selon l'une des revendications 8 à 12, comportant lors de l'étape a), la réalisation dans la structure microélectronique et/ou nanoélectronique d'au moins un plot de contact électrique destiné à assurer un contact électrique avec le via, ledit procédé comportant avantageusement pour former ledit plot de contact, un dépôt métallique supplémentaire sur celui-ci,

14. Procédé de réalisation selon l'une des revendications 8 à 13, dans lequel l'étape de scellement utilisant un film sec, le procédé de réalisation comporte les sous-étapes :
- laminage du film sec sur les faces de base des parois du capot,
- structuration du film sec,
- rapprochement du capot et du substrat comportant la ou les structures microélectronique et/ou nanoélectronique,
- application d'une pression de sorte à écraser le film sec, ou
dans lequel le scellement est un scellement eutectique ou métallique par thermo-compression, ou par scellement moléculaire ou par sérigraphie.

15. Procédé de réalisation selon l'une des revendications 8 à 14, dans lequel plusieurs dispositifs étant réalisés simultanément, ledit substrat comportant plusieurs structures microélectroniques et/ou nanoélectroniques et le substrat capot comportant plusieurs capots, les capots étant scellés simultanément sur le substrat comportant les structures microélectroniques et/ou nanoélectroniques, de sorte qu'un canal fluidique d'un dispositif puisse communiquer ou non avec le canal fluidique d'autres dispositifs, ledit procédé pouvant comporter
les étapes de :
- de réalisation de prédécoupes dans une direction perpendiculaire aux canaux fluidiques dans le substrat capot et dans le substrat,
- de séparation des dispositifs, avantageusement par clivage,
- de prédécoupes ou de découpes dans une direction parallèle aux canaux fluidiques entre les canaux,
- de séparation des dispositifs, avantageusement par clivage des prédécoupes.

## Patentansprüche

1. Vorrichtung, umfassend ein Substrat, das wenigstens eine mikroelektronische und/oder nanoelektronische Struktur (NEMS) umfasst, umfassend wenigstens einen empfindlichen Teil und einen Fluidkanal (2), der zwischen dem Substrat und einer Kappe (6) definiert ist, wobei der Fluidkanal (2) wenigstens zwei Öffnungen zum Sicherstellen einer Zirkulation in dem Kanal umfasst, wobei die mikroelektronische und/oder nanoelektronische Struktur im Inneren des Fluidkanals angeordnet ist, wobei die Kappe mit dem Substrat im Bereich einer Zusammenfügungsgrenzfläche zusammengefügt ist, wobei die Vorrichtung wenigstens eine elektrische Verbindung zwischen der mikroelektronischen und/oder nanoelektronischen Struktur und dem Äußeren des Fluidkanals (2) umfasst, wobei die elektrische Verbindung (8) durch eine Durchführung gebildet ist, die durch das Substrat (4) lotrecht zu der mikroelektronischen und/oder nanoelektronischen Struktur und im elektrischen Kontakt mit der mikroelektronischen und/oder nanoelektronischen Struktur realisiert ist, wobei die Vorrichtung ferner eine Funktionalisierungsschicht (18, 118) umfasst, die wenigstens einen Teil des empfindlichen Teils der mikroelektronischen und/oder nanoelektronischen Struktur bedeckt.

2. Vorrichtung nach Anspruch 1, bei der die Durchführung in elektrischem Kontakt mit der mikroelektronischen und/oder nanoelektronischen Struktur mittels eines Kontaktpunkts ist, der in dem Fluidkanal angeordnet ist.

3. Vorrichtung nach Anspruch 1 oder 2, ferner umfassend eine Zwischenschicht (120, 220), die wenigstens teilweise in dem Fluidkanal angeordnet ist, und die unter einem Teil der Funktionalisierungsschicht (18, 118) angeordnet ist, wobei die Zwischenschicht (120, 220) in dem Fluidkanal (2) wenigstens teilweise die mikroelektronische und/oder nanoelektronische Struktur bedeckt, mit Ausnahme ihres empfindlichen Teils.

4. Vorrichtung nach Anspruch 3, bei der die Zwischenschicht (20) eine Einkapselungsschicht ist, und/oder bei der die Zwischenschicht (20, 120, 220) ein elektrisch isolierendes Material umfasst, beispielsweise ein Siliziumoxid oder ein Siliziumnitrid, wobei die Zwischenschicht (120, 220) vorzugsweise die Verbindungsleitungen elektrisch isoliert.

5. Vorrichtung nach einem der Ansprüche 1 bis 4, umfassend mehrere mikroelektronische und/oder nanoelektronische Strukturen, die in dem Fluidkanal miteinander verbunden sind, wobei die mikroelektronischen und/oder nanoelektronischen Strukturen vorzugsweise durch Verbindungsleitungen miteinander verbunden sind, die in dem Fluidkanal angeordnet sind.

6. Vorrichtung nach einem der Ansprüche 1 bis 5, umfassend einen trockenen Versiegelungsfilm (22), der zwischen dem Substrat (4) und der Kappe eingefügt ist, wobei der trockene Versiegelungsfilm (22) vorzugsweise mehrere Bänder umfasst, oder wobei die Vorrichtung wenigstens eine Materialschicht umfasst, die zwischen dem Substrat und der Kappe (6) eingefügt ist, die eine eutektische oder metallische Versiegelung oder mittels Thermokompression realisiert, oder mittels Siebdruck oder eine molekulare Versiegelung oder eine Versiegelung mittels Glassinterung.

7. Vorrichtung nach einem der Ansprüche 1 bis 6, bei der der Kanal eine Gasphasenchromatographie-Mikrosäule bildet.

8. Verfahren zur Herstellung wenigstens einer Vorrichtung nach einem der Ansprüche 1 bis 7, umfassend die Schritte:
a) Realisieren wenigstens einer mikroelektronischen und/oder nanoelektronischen Struktur auf einem Substrat,
b) Realisieren einer Kappe (6), die einen Fluidkanal (2) umfasst, in einem Kappensubstrat,
d) Versiegeln der Kappe (6) und des Substrats derart, dass die mikroelektronische und/oder nanoelektronische Struktur in dem Fluidkanal (2) angeordnet ist,
e) Realisieren wenigstens einer Durchführung in dem Substrat lotrecht zu der mikroelektronischen und/oder nanoelektronischen Struktur,
wobei der Schritt e) nach dem Schritt d) oder vor dem Schritt d) erfolgen kann,
wobei das Verfahren ferner zwischen dem Schritt b) und dem Schritt d) umfasst:
c) Realisieren einer Funktionalisierungsschicht (18, 118) im Inneren des Fluidkanals (2) auf der mikroelektronischen und/oder nanoelektronischen Struktur, wobei die Funktionalisierungsschicht ferner auf den Wänden der Kappe (6) sein kann, wobei die Funktionalisierungsschicht (18, 118) vor der Versiegelung realisiert wird.

9. Verfahren nach Anspruch 8, bei dem die Realisierung der Durchführung wenigstens umfasst:
- den Schritt der Realisierung eines Lochs wenigstens in einem Teil des Substrats,
- den Schritt des Füllens des gesamten Lochs oder eines Teils davon mit einem elektrisch leitenden Material,
wobei das Verfahren vorzugsweise vor der Realisierung der wenigstens einen Durchführung und nach dem Schritt d) einen Schritt des Abdünnens des Substrats umfasst.

10. Verfahren nach Anspruch 9, umfassend vor dem Schritt des Füllens des Lochs mit einem elektrisch leitenden Material einen Schritt des Aufbringens eines elektrisch isolierenden Materials auf die Innenoberfläche des Lochs.

11. Verfahren nach Anspruch 9 oder 10, bei dem die Realisierung des Lochs durch ein Tiefätzen und anschließend durch ein Feinätzen erzielt wird, und/oder bei dem der empfindliche Teil der mikroelektronischen und/oder nanoelektronischen Struktur aufgehängt ist und dieser vor dem Schritt d) freigesetzt wird.

12. Verfahren nach einem der Ansprüche 8 bis 11, umfassend einen Schritt des Bildens einer Zwischenschicht auf dem Substrat nach dem Schritt a) in einer Zone derart, dass sie wenigstens einen in dem Fluidkanal angeordneten Teil umfasst, nach dem Schritt e), oder einen Schritt des Bildens einer Zwischenschicht auf dem Substrat nach dem Schritt a) in einer Zone derart, dass sie sich ausschließlich bei der Zusammenfügungsgrenzfläche befindet, nach dem Schritt e), wobei die Funktionalisierungsschicht vorzugsweise auf der Zwischenschicht gebildet wird.

13. Verfahren nach einem der Ansprüche 8 bis 12, umfassend während des Schritts a) die Realisierung, in der mikroelektronischen und/oder nanoelektronischen Struktur, wenigstens eines elektrischen Kontaktpunkts, der dazu ausgelegt ist, einen elektrischen Kontakt mit der Durchführung sicherzustellen, wobei das Verfahren vorzugsweise zur Bildung des Kontaktpunkts eine zusätzliche metallische Abscheidung auf diesem umfasst.

14. Verfahren zur Herstellung nach einem der Ansprüche 8 bis 13, bei dem der Versiegelungsschritt einen trockenen Film verwendet, wobei das Herstellungsverfahren die folgenden Teilschritte umfasst:
- Laminieren des trockenen Films auf die Basisflächen der Wände der Kappe,
- Strukturieren des trockenen Films,
- Annähern der Kappe und des Substrats, umfassend die mikroelektronische(n) und/oder nanoelektronische(n) Struktur(en),
- Ausüben eines Drucks derart, dass der trockene Film zerdrückt wird, oder
bei dem die Versiegelung eine eutektische oder metallische Versiegelung mittels Thermokompression ist, oder durch molekulare Versiegelung oder durch Siebdruck.

15. Verfahren zur Herstellung nach einem der Ansprüche 8 bis 14, bei dem mehrere Vorrichtungen gleichzeitig realisiert werden, wobei das Substrat mehrere mikroelektronische und/oder nanoelektronische Strukturen umfasst und das Kappensubstrat mehrere Kappen umfasst, wobei die Kappen gleichzeitig auf dem Substrat versiegelt werden, das die mikroelektronischen und/oder nanoelektronischen Strukturen umfasst, derart, dass ein Fluidkanal einer Vorrichtung wohl oder nicht mit dem Fluidkanal von anderen Vorrichtungen kommunizieren kann, wobei das Verfahren die Schritte umfassen kann:
- Realisieren von Vorausschneidungen in einer Richtung orthogonal zu den Fluidkanälen in dem Kappensubstrat und in dem Substrat,
- Separieren der Vorrichtungen, vorzugsweise durch Spaltung,
- Vorausschneiden oder Ausschneiden in einer Richtung parallel zu den Fluidkanälen zwischen den Kanälen,
- Separieren der Vorrichtungen, vorzugsweise durch Spalten der Vorausschneidungen.

## Claims

1. A device comprising a substrate comprising at least one microelectronic and/or nanoelectronic structure (NEMS) comprising at least one sensitive portion and one fluid channel (2) defined between said substrate and a cap (6), said fluid channel (2) comprising at least two apertures to provide a flow in said channel, said microelectronic and/or nanoelectronic structure being located within the fluid channel, said cap being assembled with the substrate at an assembly interface, said device comprising at least one electrical connection between said microelectronic and/or nanoelectronic structure and the exterior of the fluid channel (2), the electrical connection (8) being formed by a via made through the substrate (4) directly below the microelectronic and/or nanoelectronic structure, and in electrical contact with the microelectronic and/or nanoelectronic structure, said device also comprising a functionalisation layer (24, 224) at least partly covering a part of the sensitive portion of the microelectronic and/or nanoelectronic structure.

2. A device according to claim 1, in which the via is in electrical contact with the microelectronic and/or nanoelectronic structure through a contact contact located in the fluid channel.

3. A Device according to claim 1 or 2, in which the device also comprises an intermediate layer (120, 220) located at least partly in the fluid channel and located below a part of the functionalisation layer (18, 118), said intermediate layer (120, 220) covering, in the fluid channel (2), at least partly the microelectronic and/or nanoelectronic structure, except for its sensitive portion.

4. A device according to claim 3, in which the intermediate layer is an encapsulation layer and/or in which the intermediate layer (20, 120, 220) comprises an electrically insulating material, such as a silicon oxide or a silicon nitride, the intermediate layer (20, 120, 220) advantageously insulating the interconnection lines.

5. A device according to one of the claims 1 to 4, comprising several microelectronic and/or nanoelectronic structures interconnected in said fluid channel, the microelectronic and/or nanoelectronic structures being advantageously interconnected by interconnection lines positioned in the fluid channel.

6. A device according to one of the claims 1 to 5, comprising a dry sealing film (22) interposed between the substrate (4) and the cap, the dry sealing film (22) advantageously comprising several beads, or the device comprising at least one layer of material interposed between the substrate and the cap (6) making a eutectic or metallic sealing, or thermocompression sealing, or screen print sealing, or in which the sealing is molecular sealing or glass frit.

7. A device according to one of the claims 1 to 6, in which the channel forms a gas chromatography microcolumn.

8. A method for production of at least one device according to one of claims 1 to 7, comprising the following steps:
a) production of at least one microelectronic and/or nanoelectronic structure on a substrate,
b) production of a cap (6) comprising a fluid channel (2), in a cap substrate,
d) sealing of the cap and of the substrate such that the microelectronic and/or nanoelectronic structure is located in the fluid channel,
e) production of at least one via in the substrate directly below the microelectronic and/or nanoelectronic structure,
in which step e) can take place after step d) or before step d).
the method also comprising between step b) and step d):
c) production of a functionalisation layer inside the fluid channel on the microelectronic and/or nanoelectronic structure and/or on the walls of the cap and/or on the intermediate layer, where said step is accomplished before sealing.

9. A method according to claim 8, in which the production of the via comprises at least
- The step of production of a hole in at least a portion of the substrate,
- The step of filling all or part of said hole with an electrically conductive material,
the method advantageously comprising, prior to the production of the at least one via, and after step d), a step of thinning of the substrate.

10. A method according to claim9 comprising, prior to the step of filling of said hole with an electrically conductive material, a step of deposition on the inner surface of the hole of an electrically insulating material.

11. A method according to claim 9 or 10, in which the hole is produced by deep etching followed by fine etching and/or in which the sensitive portion of the microelectronic and/or nanoelectronic structure being suspended, it is released before step d).

12. A method according to one of the claims 8 to 11, comprising a step of formation of an intermediate layer on the substrate after step a) in an area such that it comprises at least one portion located in the fluid channel after step e) or a step of formation of an intermediate layer on the substrate after step a) in an area such that it is located only at the assembly interface after step e), the functionalisation layer being advantageously formed on the intermediate layer.

13. A method according to one of the claims 8 to 12, comprising, in step a), production in the microelectronic and/or nanoelectronic structure of at least one electrical contact pad intended to provide an electrical contact with the via, the method advantageously comprising, to form said contact pad, an additional metal deposition on the contact pad.

14. A method of production according to one of the claims 8 to 13, in which the step of sealing uses a dry film, where the method of production comprises the following sub-steps:
- lamination of the dry film on the under-faces of the walls of the cap,
- structuring of the dry film,
- bringing the cap and the substrate with the microelectronic and/or nanoelectronic structure(s) closer,
- application of a pressure so as to press the dry film, or in which the sealing is a eutectic or metal thermocompression sealing, or sealing by molecular sealing, or by screen print.

15. A method of production according to one of the claims 8 to 14, in which several devices are produced simultaneously, the substrate comprising several microelectronic and/or nanoelectronic structures and the cap substrate comprises several caps, where the caps are sealed simultaneously on the substrate comprising the microelectronic and/or nanoelectronic structures, such that a fluid channel of a device can or cannot communicate with the fluid channel of other devices, in which said method can comprise the steps:
- a step of production of pre-cuts in a direction perpendicular to the fluid channels in the cap substrate and in the substrate,
- a step of separation of the devices, advantageously by cleavage,
- a step of pre-cutting or of cutting in a direction parallel to the fluid channels between the channels,
- a step of separation of the devices, advantageously by cleavage of the pre-cuts.
